# EUROPEAN PATENT APPLICATION

(11) **EP 4 827 275 A1**
(43) Date of publication of application: **21.10.2026**
(21) Application number: 24953513.9
(22) Date of filing: 24.09.2024
(51) Int. Cl.: H10D 86/60, H10H 29/49, H10K 59/131, H10K 59/121

(54) **DISPLAY PANEL AND DISPLAY APPARATUS**

(30) Priority: 05.09.2024 CN 202411244774
(71) Applicant: Wuhan Tianma Microelectronics Co., Ltd., Wuhan, Hubei 430205 (CN)
(72) Inventor: ZHOU, Shu, Wuhan, Hubei 430205 (CN)
(74) Representative: Lorenz & Kollegen
(86) International application number: PCT/CN2024/120568
(87) International publication number: WO 2026/051127

(57) **Abstract**

Embodiments of the present disclosure provide a display panel and a display device, relating to the field of display technologies, and are configured for improving the brightness uniformity of the display panel. The display panel includes a substrate, a data line and a pixel driving circuit that are located on a side of the substrate. The pixel driving circuit includes a driving transistor, a bias adjustment transistor and a first connection component. A gate of the driving transistor is electrically connected to a first node, a first electrode of the driving transistor is electrically connected to a second node, and a second electrode of the driving transistor is electrically connected to a third node. The first connection component electrically connects the bias adjustment transistor and the second node. The display panel further includes a first semiconductor layer and a first metal layer, and the first semiconductor layer and the first metal layer are sequentially stacked along a direction away from the substrate. The first semiconductor layer includes a channel of the driving transistor and a channel of the bias adjustment transistor, and the first metal layer includes a gate of the driving transistor and a gate of the bias adjustment transistor. The first connection component is located in the first semiconductor layer.

## Description

### CROSS-REFERENCE TO RELATED APPLICATION

The present application claims priority to Chinese Patent Application No. 202411244774.9, entitled "Display Panel and Display Device", filed on Sep 05, 2024, the content of which is incorporated herein by reference in its entirety.

### TECHNICAL FIELD

The present disclosure relates to the field of display technologies, and in particular, to a display panel and a display device.

### BACKGROUND

Organic Light Emitting Diode (OLED) displays are currently one of the research hotspots in the field of flat-panel displays. Compared with Liquid Crystal Displays (LCD), OLEDs have advantages such as low energy consumption, low production costs, self-luminescence, wide viewing angles, and fast response times. At present, in the field of flat-panel displays for mobile phones, PDAs, digital cameras, etc., OLEDs have begun to replace traditional LCDs.

A pixel driving circuit in an OLED display panel provides the driving current required for the light-emitting elements to enable the display panel to emit light and display. However, currently, display panels suffer from the phenomenon of visible Mura in a display state, which affects the display quality.

### SUMMARY

In view of this, the present disclosure provides a display panel and a display device to improve the display uniformity of the display panel.

In a first aspect, an embodiment of the present disclosure provides a display panel, including a substrate; a data line and a pixel driving circuit that are located on a side of the substrate. The pixel driving circuit includes a driving transistor, a bias adjustment transistor and a first connection component. A gate of the driving transistor is electrically connected to a first node, a first electrode of the driving transistor is electrically connected to a second node, and a second electrode of the driving transistor is electrically connected to a third node. The first connection component is electrically connected to the bias adjustment transistor and the second node. The display panel further includes a first semiconductor layer and a first metal layer, and the first semiconductor layer and the first metal layer are sequentially stacked along a direction away from the substrate. The first semiconductor layer includes a channel of the driving transistor and a channel of the bias adjustment transistor, and the first metal layer includes the gate of the driving transistor and a gate of the bias adjustment transistor. The first connection component is located in the first semiconductor layer.

In a second aspect, an embodiment of the present disclosure provides a display device including the above display panel.

According to the display panel and the display device provided by the embodiments of the present disclosure, the first connection component is provided in the first semiconductor layer, and the data line may be provided on a side of the second metal layer away from the substrate, for example, the data line is provided in the second source-drain layer having a larger distance from the first semiconductor layer, thereby increasing a distance between the first connection component and the data line along a direction perpendicular to a plane of the substrate, reducing a coupling capacitance between the first connection component and the data line. When the data voltage changes, the signal variation of the second node may be weakened, thereby preventing the potential change of the second node from affecting the potential of the first node through the driving transistor and the threshold compensation transistor, avoiding affecting the light-emitting brightness of the light-emitting element and thus improving the brightness uniformity of the display panel.

### BRIEF DESCRIPTION OF DRAWINGS

In order to describe the technical solutions in the embodiments of the present disclosure more clearly, the drawings desired in the description of the embodiments will be briefly introduced as follows. Obviously, the drawings in the following description are only some of the embodiments of the present disclosure. For those ordinarily skilled in the art, other drawings can also be obtained in accordance with these drawings without any creative effort.
FIG. 1 is a simplified schematic diagram of a display panel according to an embodiment of the present disclosure;
FIG. 2 is a schematic circuit diagram of a sub-pixel in FIG. 1;
FIG. 3 is an operation timing diagram of a pixel driving circuit according to an embodiment of the present disclosure;
FIG. 4 is a schematic wiring diagram of a pixel driving circuit according to an embodiment of the present disclosure;
FIG. 5 is a schematic cross-sectional diagram of a display panel according to an embodiment of the present disclosure;
FIG. 6 is a schematic top view of a first semiconductor layer according to an embodiment of the present disclosure;
FIG. 7 is a schematic top view of a first metal layer according to an embodiment of the present disclosure;
FIG. 8 is a schematic top view of a second metal layer according to an embodiment of the present disclosure;
FIG. 9 is a schematic top view of a second semiconductor layer according to an embodiment of the present disclosure;
FIG. 10 is a schematic top view of a third metal layer according to an embodiment of the present disclosure;
FIG. 11 is a schematic top view of a first source-drain layer according to an embodiment of the present disclosure;
FIG. 12 is a schematic top view of a second source-drain layer according to an embodiment of the present disclosure;
FIG. 13 is an enlarged schematic diagram of a light-emitting control signal line according to an embodiment of the present disclosure;
FIG. 14 is an enlarged schematic diagram of another light-emitting control signal line according to an embodiment of the present disclosure;
FIG. 15 is a schematic top view of another first semiconductor layer according to an embodiment of the present disclosure;
FIG. 16 is a simplified schematic diagram of another display panel according to an embodiment of the present disclosure;
FIG. 17 is a schematic wiring diagram of another pixel driving circuit according to an embodiment of the present disclosure;
FIG. 18 is a schematic top view of another first source-drain layer according to an embodiment of the present disclosure;
FIG. 19 is a schematic top view of another second source-drain layer according to an embodiment of the present disclosure;
FIG. 20 is a simplified schematic diagram of another display panel according to an embodiment of the present disclosure;
FIG. 21 is a simplified schematic diagram of another display panel according to an embodiment of the present disclosure;
FIG. 22 is a simplified schematic diagram of another display panel according to an embodiment of the present disclosure;
FIG. 23 is a simplified schematic diagram of another display panel according to an embodiment of the present disclosure;
FIG. 24 is a simplified schematic diagram of another display panel according to an embodiment of the present disclosure;
FIG. 25 is a schematic wiring diagram of another pixel driving circuit according to an embodiment of the present disclosure;
FIG. 26 is a schematic diagram of a second plate and a shielding component in FIG. 25;
FIG. 27 is a schematic wiring diagram of another pixel driving circuit according to an embodiment of the present disclosure;
FIG. 28 is a schematic diagram of a shielding component and a second bias adjustment signal sub-line in FIG. 27;
FIG. 29 is a schematic wiring diagram of another pixel driving circuit according to an embodiment of the present disclosure;
FIG. 30 is a schematic diagram of a shielding component and a fourth reset signal sub-line in FIG. 29; and
FIG. 31 is a schematic diagram of a display device according to an embodiment of the present disclosure.

### DESCRIPTION OF EMBODIMENTS

In order to better understand technical solutions of the present disclosure, embodiments of the present disclosure are described in detail below in conjunction with the drawings.

It should be made clear that the embodiments described are only part of rather than all of the embodiments of the present disclosure. All other embodiments obtained by those skilled in the art without creative efforts according to the embodiments of the present disclosure shall fall within a scope of the present disclosure.

The terms used in the embodiments of the present disclosure are only for the purpose of describing specific embodiments, and are not intended to limit the present disclosure. The singular forms "a/an", "said", and "the" used in the embodiments of the present disclosure and the attached claims are also intended to include plural forms thereof, unless noted otherwise.

It should be understood that the term "and/or" used in the context of the present disclosure is to describe an associative relationship of associated objects, indicating that there may be three relationships, e.g., A and/or B may indicate only A, both A and B, and only B. In addition, the character "/" in the context generally indicates that the associated objects have an "or" relationship.

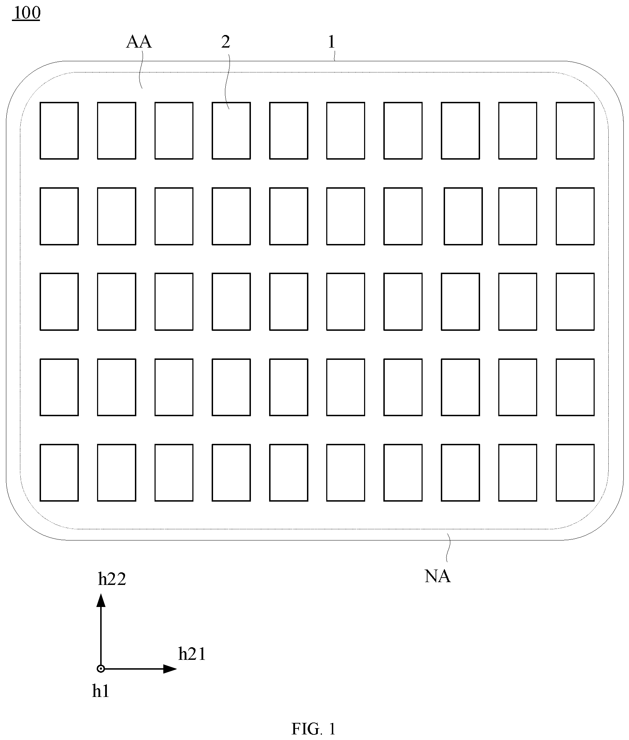

An embodiment of the present disclosure provides a display panel, as shown in FIG. 1, which is a simplified schematic diagram of a display panel according to an embodiment of the present disclosure, the display panel 100 includes a substrate 1 and a plurality of sub-pixels 2 located on a side of the substrate 1. The display panel 100 includes a display region AA, and the sub-pixels 2 are located in the display region AA.

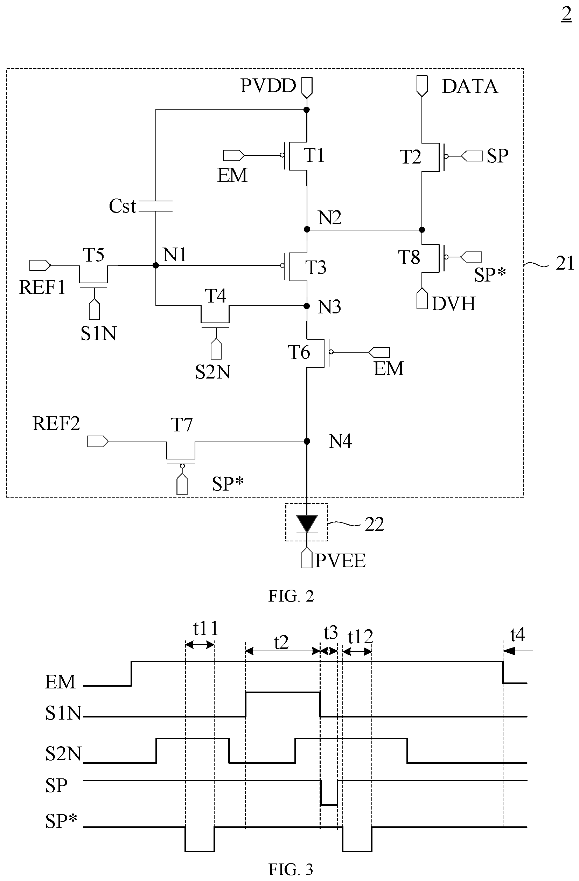

As shown in FIG. 2, which is a schematic circuit diagram of a sub-pixel in FIG. 1, and the sub-pixel 2 includes a pixel driving circuit 21 and a light-emitting element 22 that are electrically connected. Exemplarily, the light-emitting element 22 includes any one of an organic light-emitting diode (OLED), a quantum dots light-emitting diode (QLED), and a micro light-emitting diode (Micro-LED).

As shown in FIG. 2, the pixel driving circuit 21 includes a first light-emitting control transistor T1, a data writing transistor T2, a driving transistor T3, a threshold compensation transistor T4, a first reset transistor T5, a second light-emitting control transistor T6, a second reset transistor T8, and a bias adjustment transistor T8.

As shown in FIG. 2, the display panel 100 further includes a data line DATA, a first power supply voltage line PVDD, a bias adjustment signal line DVH, a first reset signal line REF1, a second reset signal line REF2, a first scan control signal line SP*, a second scan control signal line S1N, a third scan control signal line S2N, a light-emitting control signal line EM, and a fourth scan control signal line SP.

The first power supply voltage line PVDD transmits a first power supply voltage Vpvdd. The data line DATA transmits a data voltage Vdata. The first reset signal line REF1 transmits a first reset voltage Vref1. The second reset signal line REF2 transmits a second reset voltage Vref2. The bias adjustment signal line DVH transmits a bias adjustment voltage Vdvh.

The first light-emitting control transistor T1 has a gate electrically connected to the light-emitting control signal line EM, a first electrode electrically connected to the first power supply voltage line PVDD, and a second electrode electrically connected to a second node N2.

The data writing transistor T2 has a gate electrically connected to the fourth scan control signal line SP, a first electrode electrically connected to the data line DATA, and a second electrode electrically connected to the second node N2.

The driving transistor T3 has a gate electrically connected to a first node N1, a first electrode electrically connected to the second node N2, and a second electrode electrically connected to a third node N3.

The threshold compensation transistor T4 has a gate electrically connected to the third scan control signal line S2N, a first electrode electrically connected to the third node N3, and a second electrode electrically connected to the first node N1.

The first reset transistor T5 has a gate electrically connected to the second scan control signal line S1N, a first electrode electrically connected to the first reset signal line REF1, and a second electrode electrically connected to the first node N1.

The second light-emitting control transistor T6 has a gate electrically connected to the light-emitting control signal line EM, a first electrode electrically connected to the third node N3, and a second electrode electrically connected to the light-emitting element 22.

The second reset transistor T7 has a gate electrically connected to the first scan control signal line SP*, a first electrode electrically connected to the second reset signal line REF2, and a second electrode electrically connected to the light-emitting element 22.

The bias adjustment transistor T8 has a gate electrically connected to the first scan control signal line SP*, a first electrode electrically connected to the bias adjustment signal line DVH, and a second electrode electrically connected to the second node N2.

As shown in FIG. 2, the pixel driving circuit 21 further includes a storage capacitor Cst. The storage capacitor Cst has a first plate electrically connected to the first node N1, and a second plate electrically connected to the first power supply voltage line PVDD.

As shown in FIG. 3, which is an operation timing diagram of a pixel driving circuit according to an embodiment of the present disclosure, a driving period of the pixel driving circuit 21 includes a first bias adjustment phase t11, a reset phase t2, a data writing and threshold compensation phase t3, a second bias adjustment phase t12, and a light-emitting phase t4.

In the first bias adjustment phase t11, the first scan control signal line SP* provides an enable level, the bias adjustment transistor T8 is turned on, the bias adjustment voltage Vdvh provided by the bias adjustment signal line DVH is written into the second node N2, and the potential of the first electrode of the driving transistor T3 is refreshed, thereby configuring the device characteristic of the driving transistor T3 to a determined initial state, and thus eliminating the influence of the data voltage written in the previous frame on the device characteristic of the driving transistor T3.

In the reset phase t2, the second scan control signal line S1N provides an enable level, the first reset transistor T5 is turned on, and the first reset voltage Vref1 transmitted by the first reset signal line REF1 resets a potential of the first node N1 through the first reset transistor T5.

In the data writing and threshold compensation phase t3, the fourth scan control signal line SP provides an enable level, the data writing transistor T2 is turned on, the third scan control signal line S2N provides an enable level, the threshold compensation transistor T4 is turned on, and the data voltage Vdata transmitted by the data line DATA is written into the first node N1 through the data writing transistor T2, the driving transistor T3 and the threshold compensation transistor T4 until the driving transistor T3 is turned off, and at this time, a voltage difference between the gate and the source of the driving transistor T3 is the threshold voltage thereof, thereby compensating the threshold voltage of the driving transistor T3.

In the second bias adjustment phase t12, the first scan control signal line SP* provides the enable level, the bias adjustment transistor T8 is turned on, and the bias adjustment voltage Vdvh provided by the bias adjustment signal line DVH is written into the second node N2 to perform potential refreshing on the first electrode of the driving transistor T3. In the related art, after writing the data voltage to the gate of the driving transistor T3, i.e., the first node N1, the voltage at the first electrode of the driving transistor T3, i.e., the second node N2, may experience leakage, resulting in a significant shift in the potential of the first electrode of the driving transistor T3. In this embodiment of the present disclosure, a second bias adjustment phase t12 is provided, during which the bias adjustment transistor T8 is controlled to turn on, the bias adjustment voltage Vdvh is written to the first electrode of the driving transistor T3 via the bias adjustment transistor T8, where the bias adjustment voltage Vdvh is related to the data voltage Vdata, thereby enabling the bias state of the driving transistor T3 to remain consistent with the bias state when the data voltage is just written, enhancing the stability of the operating state of the driving transistor T3, mitigating the low-frequency flicker issue, and thus improving the display effect of the display panel 100.

In the second bias adjustment phase t12, the first scan control signal line SP* provides the enable level, the second reset transistor T7 is turned on, and the second reset voltage Vref2 provided by the second reset signal line REF2 is written into an anode of the light-emitting element 22 to reset an anode potential of the light-emitting element 22.

In the light-emitting phase t3, the light-emitting control signal line EM provides an enable level, the first light-emitting control transistor T1 and the second light-emitting control transistor T6 are turned on, and the light-emitting element 22 emits light.

Exemplarily, at least one of the first light-emitting control transistor T1, the data writing transistor T2, the driving transistor T3, the second light-emitting control transistor T6 and the second reset transistor T7 may be configured to include a Low Temperature Poly Silicon (LTPS) transistor.

In an embodiment of the present disclosure, at least one of the first reset transistor T5 and the threshold compensation transistor T4 may be configured to include an oxide transistor. Exemplarily, the oxide transistor includes indium gallium zinc oxide (IGZO).

The oxide transistor has the advantages of low leakage current and the like, and the low temperature polysilicon transistor has the advantages of high switching speed, high carrier mobility, low power and the like. In the embodiments of the present disclosure, by adopting the display panel technology of LTPO (Low Temperature Polycrystalline Oxide) combining LTPO and IGZO, the display panel not only has the advantages of high resolution, high reaction speed, high brightness, high aperture ratio and the like of the LTPS display panel, but also has the advantage of low leakage current of IGZO, thereby improving the potential stability of the first node N1, improving the display effect, and thus being beneficial to improving the display effect at low frequency. FIG. 2 illustrates that the first light-emitting control transistor T1, the data writing transistor T2, the driving transistor T3, the second light-emitting control transistor T6, and the second reset transistor T7 are all configured as low temperature polysilicon transistors, while the first reset transistor T5 and the threshold compensation transistor T4 are both configured to include the oxide transistor.

Exemplarily, the first light-emitting control transistor T1, the data writing transistor T2, the driving transistor T3, the second light-emitting control transistor T6, and the reset transistor T7 may be P-type transistors, and the first reset transistor T5 and the threshold compensation transistor T3 may be N-type transistors. When a voltage difference between the gate and the source of the P-type transistor is less than the threshold voltage, it may also be understood that the P-type transistor is turned on at a low level, that is, the enable level is a low level. When a voltage difference between the gate and the source of the N-type transistor is greater than the threshold voltage, it may also be understood that the N-type transistor is turned on at a high level, that is, the enable level is a high level.

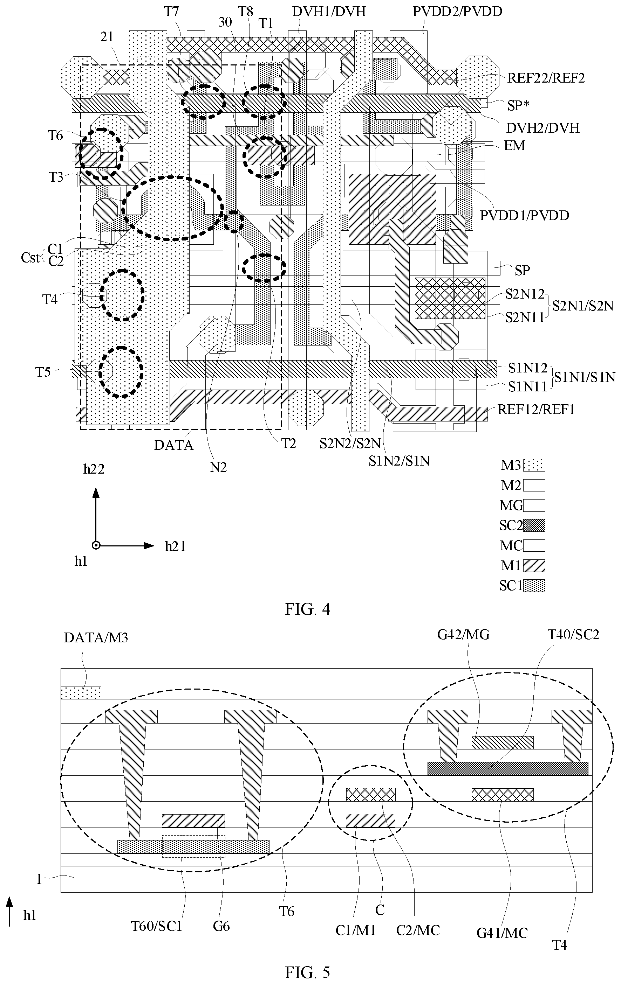

Referring to FIG. 2 and FIG. 4, where FIG. 4 is a schematic wiring diagram of a pixel driving circuit according to an embodiment of the present disclosure, two pixel driving circuits 21 arranged along a first direction h21, the pixel driving circuit 21 further includes a first connection component 30. The first connection component 30 electrically connects the bias adjustment transistor T8 and the second node N2.

As shown in FIG. 4 and FIG. 5, where FIG. 5 is a cross-sectional schematic diagram of a display panel according to an embodiment of the present disclosure, the display panel 100 further includes a plurality of conductive film layers, and the conductive film layers include a first semiconductor layer SC1, a first metal layer M1, and a second metal layer MC. Along a direction away from the substrate 1, the first semiconductor layer SC1, the first metal layer M1 and the second metal layer MC are sequentially stacked, and two adjacent conductive film layers are separated by an insulating layer.

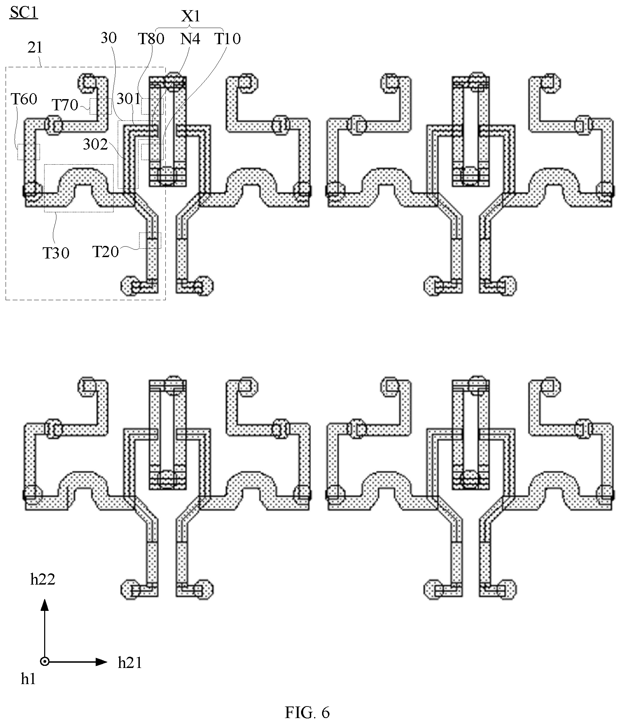

Referring to FIG. 4 and FIG. 6, where FIG. 6 is a schematic top view of a first semiconductor layer according to an embodiment of the present disclosure, two pixel driving circuit rows and four pixel driving circuit columns are shown, the pixel driving circuit row includes a plurality of pixel driving circuits 21 arranged along a first direction h21. The pixel driving circuit column includes a plurality of pixel driving circuits 21 arranged along a second direction h22. The first semiconductor layer SC1 includes at least a channel T10 of the first light-emitting control transistor T1, a channel T20 of the data writing transistor T2, a channel T30 of the driving transistor T3, a channel T60 of the second light-emitting control transistor T6, a channel T70 of the second reset transistor T7, and a channel T80 of the bias adjustment transistor T8.

In an embodiment, the first semiconductor layer SC1 includes a silicon material, which includes amorphous silicon or polysilicon, and the polysilicon may include low temperature polysilicon.

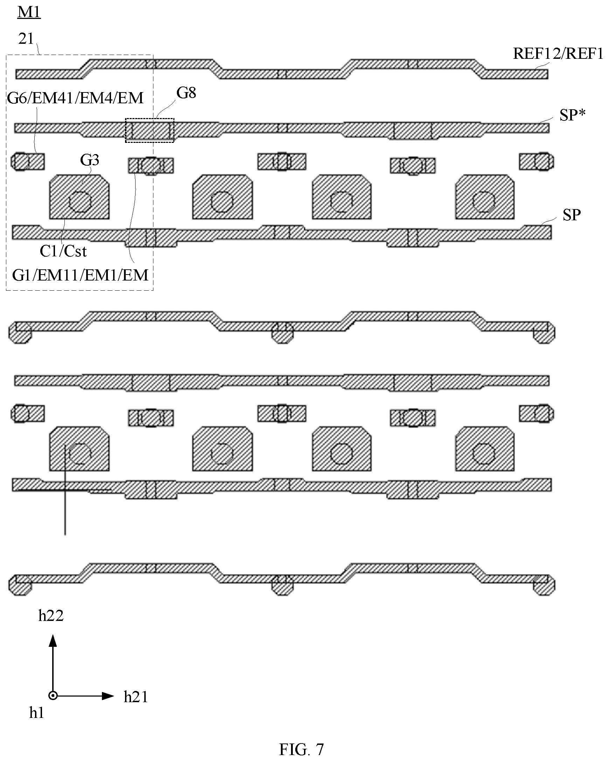

Referring to FIG. 4 and FIG. 7, where FIG. 7 is a schematic top view of a first metal layer according to an embodiment of the present disclosure, two pixel driving circuit rows and four pixel driving circuit columns are shown, the pixel driving circuit row includes a plurality of pixel driving circuits 21 arranged along a first direction h21. The pixel driving circuit column includes a plurality of pixel driving circuits 21 arranged along a second direction h22. The first metal layer M1 includes a first plate C1 of the storage capacitor Cst, a gate G3 of the driving transistor T3, and a gate G8 of the bias adjustment transistor T8. Along a direction h1 perpendicular to the plane of substrate 1, the first electrode C1 of the storage capacitor Cst is located between substrate 1 and a second electrode C2, and the gate G3 of the driving transistor T3 overlaps with the channel of the driving transistor T3, while the gate G8 of the bias adjustment transistor T8 overlaps with the channel T80 of the bias adjustment transistor T8. A portion of the first plate C1 of the storage capacitor Cst overlapping with the channel T30 of the driving transistor T3 is multiplexed as the gate G3 of the driving transistor T3.

In an embodiment, the first conductive layer M1 may include an alloy composed of one or more kinds of material such as aluminum (Al), platinum (Pt), palladium (Pd), silver (Ag), magnesium (Mg), gold (Au), nickel (Ni), neodymium (Nd), iridium (Ir), chromium (Cr), lithium (Li), calcium (Ca), molybdenum (Mo), titanium (Ti), tungsten (W), and copper (Cu), and may be formed into a single-layer or multi-layer structure.

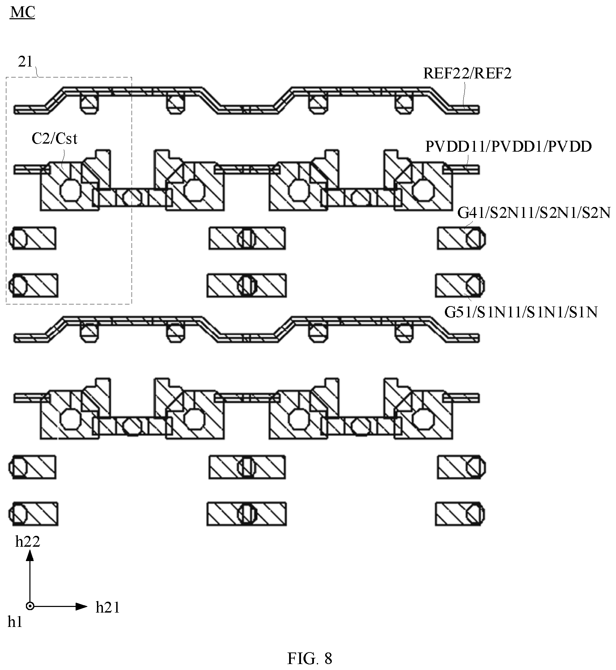

Referring to FIG. 4 and FIG. 8, where FIG. 8 is a schematic top view of a second metal layer according to an embodiment of the present disclosure, two pixel driving circuit rows and four pixel driving circuit columns are shown, the pixel driving circuit row includes a plurality of pixel driving circuits 21 arranged along a first direction h21. The pixel driving circuit column includes a plurality of pixel driving circuits 21 arranged along a second direction h22. The second metal layer MC includes a second plate C2 of the storage capacitor Cst. Along the direction h1 perpendicular to the plane of the substrate 1, the second plate C2 at least partially overlaps with the first plate C1.

Exemplarily, the second metal layer MC may include an alloy composed of one or more kinds of material such as aluminum (Al), platinum (Pt), palladium (Pd), silver (Ag), magnesium (Mg), gold (Au), nickel (Ni), neodymium (Nd), iridium (Ir), chromium (Cr), lithium (Li), calcium (Ca), molybdenum (Mo), titanium (Ti), tungsten (W), and copper (Cu), and may be formed into a single-layer or multi-layer structure.

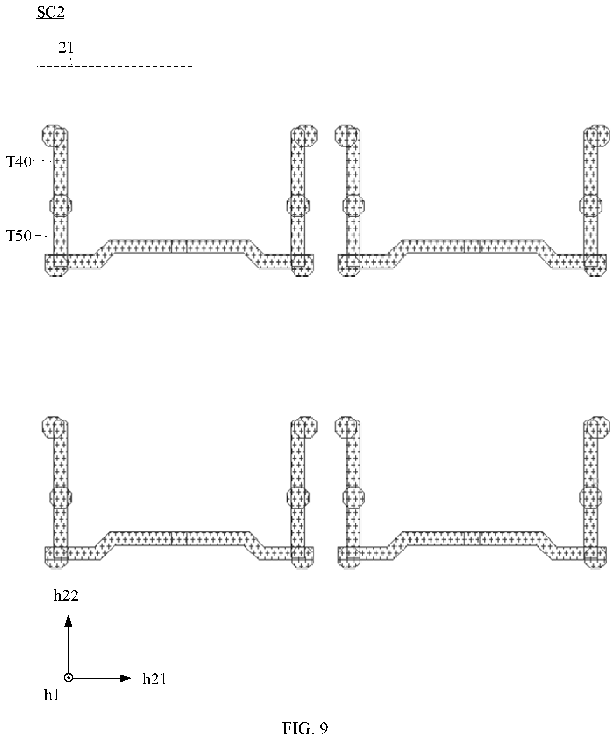

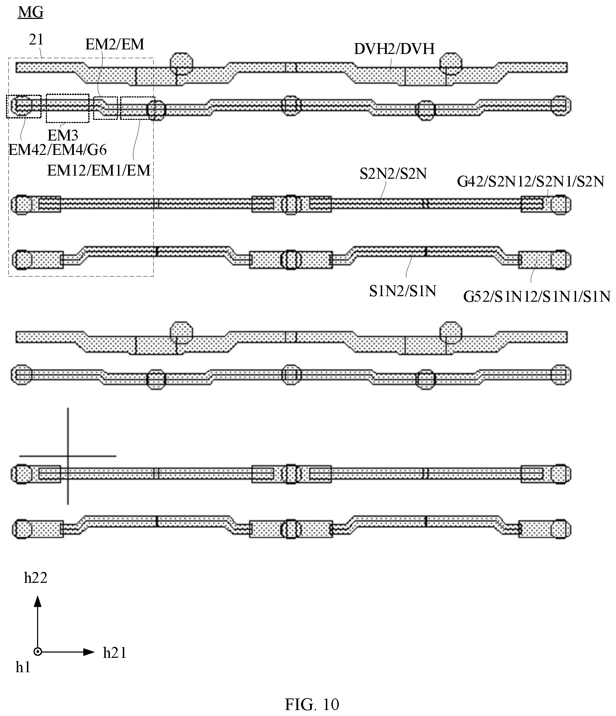

Exemplarily, the first reset transistor T5 may include an oxide transistor. When the first reset transistor T5 includes an oxide transistor, in an embodiment of the present disclosure, the first reset transistor T5 may be configured as a top-bottom dual-gate transistor. In an embodiment of the present disclosure, as shown in FIG. 5, the conductive film layers further include a second semiconductor layer SC2 and a third metal layer MG located on a side of the second metal layer MC away from the substrate 1, and the third metal layer MG is located on a side of the second semiconductor layer SC2 away from the substrate 1. Exemplarily, with reference to FIG. 4, FIG. 5, FIG. 9 and FIG. 10, where FIG. 9 is a schematic top view of a second semiconductor layer according to an embodiment of the present disclosure, and FIG. 10 is a schematic top view of a third metal layer according to an embodiment of the present disclosure, two pixel driving circuit rows and four pixel driving circuit columns are shown, the pixel driving circuit row includes a plurality of pixel driving circuits 21 arranged along a first direction h21, the pixel driving circuit column includes a plurality of pixel driving circuits 21 arranged along a second direction h22, and the second semiconductor layer SC2 includes a channel T50 of the first reset transistor T5.

In an embodiment, the second semiconductor layer SC2 includes an oxide semiconductor, such as the IGZO.

Exemplarily, as shown in FIG. 8, a bottom gate G51 of the first reset transistor T5 may also be provided in the second metal layer MC.

As shown in FIG. 10, in an embodiment of the present disclosure, a top gate G52 of the first reset transistor T5 may be provided in the third metal layer MG, and along the direction h1 perpendicular to the plane of the substrate 1, the channel T50 of the first reset transistor T5 at least partially overlaps with the bottom gate G51 and the top gate G52 of the first reset transistor T5, respectively.

As shown in FIG. 4, the display panel 100 further includes a second scan control signal line S1N. The second scan control signal line S1N includes a fourth portion S1N1 and a fifth portion S1N2. Along the direction h1 perpendicular to the plane of the substrate 1, the fourth portion S1N1 overlaps with the channel T50 of the first reset transistor T5, while the fifth portion S1N2 does not overlap with the channel T50 of the first reset transistor T5. In an embodiment of the present disclosure, the fourth portion S1N1 includes a third sub-portion S1N11 and a fourth sub-portion S1N12 that are stacked and electrically connected to each other. The third sub-portion S1N11 is located on a side of the second semiconductor layer SC2 close to the substrate 1, and the fourth sub-portion S1N12 is located on a side of the second semiconductor layer SC2 away from the substrate 1. The third sub-portion S1N11 may be multiplexed as the bottom gate G51 of the first reset transistor T5, and the fourth sub-portion S1N12 may be multiplexed as the top gate G52 of the first reset transistor T5. Based on this arrangement, the control effect of turning on and off the first reset transistor T5 can be made more stable.

Exemplarily, as shown in FIG. 4 and FIG. 8, the third sub-portion S1N11 may be located in the second metal layer MC. As shown in FIG. 4 and FIG. 10, the fourth sub-portion S1N12 may be located in the third metal layer MG.

In an embodiment of the present disclosure, the fifth portion S1N2 and the fourth sub-portion S1N12 may be provided in a same layer, and FIG. 10 illustrates that both the fifth portion S1N2 and the fourth sub-portion S1N12 are provided in the third metal layer MG.

Exemplarily, the third metal layer MG may include an alloy composed of one or more kinds of material such as aluminum (Al), platinum (Pt), palladium (Pd), silver (Ag), magnesium (Mg), gold (Au), nickel (Ni), neodymium (Nd), iridium (Ir), chromium (Cr), lithium (Li), calcium (Ca), molybdenum (Mo), titanium (Ti), tungsten (W), and copper (Cu), vanadium (V), and may be formed into a single-layer or multi-layer structure.

In an embodiment of the present disclosure, the threshold compensation transistor T4 may further include an oxide transistor. When the threshold compensation transistor T4 includes an oxide transistor, in an embodiment of the present disclosure, the threshold compensation transistor T4 may be configured as a top-bottom dual-gate transistor.

As shown in FIG. 9, the second semiconductor layer SC2 includes a channel T40 of the threshold compensation transistor T4.

Exemplarily, as shown in FIG. 8, the bottom gate G41 of the threshold compensation transistor T4 may also be provided in the second metal layer MC. As shown in FIG. 10, a top gate G42 of the threshold compensation transistor T4 may also be provided in the third metal layer MG. Along the direction h1 perpendicular to the plane of the substrate 1, the channel T40 of the threshold compensation transistor T4 at least partially overlaps with the bottom gate G41 and the top gate G42 of the threshold compensation transistor T4, respectively.

Exemplarily, as shown in FIG. 4, the display panel 100 further includes a third scan control signal line S2N. The third scan control signal line S2N includes a sixth portion S2N1 and a seventh portion S2N2. Along the direction h1 perpendicular to the plane of the substrate 1, the sixth portion S2N1 overlaps with the channel T40 of the threshold compensation transistor T4, and the seventh portion S2N2 does not overlap with the channel T40 of the threshold compensation transistor T4. The sixth portion S2N1 includes a fifth sub-portion S2N11 and a sixth sub-portion S2N12 that are stacked and electrically connected to each other. The fifth sub-portion S2N11 is located on a side of the second semiconductor layer SC2 close to the substrate 1, and the sixth sub-portion S2N12 is located on a side of the second semiconductor layer SC2 away from the substrate 1. The fifth sub-portion S2N11 may configured as the bottom gate G41 of the threshold compensation transistor T4, and the sixth sub-portion S2N12 may configured as the top gate G42 of the threshold compensation transistor T4. Based on this arrangement, the control effect of turning on and off the threshold compensation transistor T4 can be made more stable.

Exemplarily, as shown in FIG. 4 and FIG. 8, the fifth sub-portion S2N11 may be located in the second metal layer MC. As shown in FIG. 4 and FIG. 10, in an embodiment of the present disclosure, the sixth sub-portion S2N12 may be located in the third metal layer MG.

In an embodiment of the present disclosure, the sixth sub-portion S2N12 and the seventh portion S2N2 may be provided in a same layer, and FIG. 10 illustrates that both the sixth sub-portion S2N12 and the seventh portion S2N2 are provided in the third metal layer MG.

In an embodiment, as shown in FIG. 9, the channel T50 of the first reset transistor T5 and the channel T40 of the threshold compensation transistor T4 are arranged along the second direction h22, and both extend along the second direction h22.

Exemplarily, as shown in FIG. 5, the display panel further includes a first source-drain layer M2 located on a side of the second metal layer MC away from the substrate 1. As shown in FIG. 5, when the display panel includes the third metal layer MG, the first source-drain layer M2 is located on a side of the third metal layer MG away from the substrate 1.

Exemplarily, the first source-drain layer M2 may include an alloy composed of one or more kinds of material such as aluminum (Al), platinum (Pt), palladium (Pd), silver (Ag), magnesium (Mg), gold (Au), nickel (Ni), neodymium (Nd), iridium (Ir), chromium (Cr), lithium (Li), calcium (Ca), molybdenum (Mo), titanium (Ti), tungsten (W), and copper (Cu), and may be formed into a single-layer or multi-layer structure. For example, the first source-drain layer M2 may be formed as a three-layer structure including Ti-Al-Ti, so as to reduce the resistance of traces provided in the first source-drain layer M2.

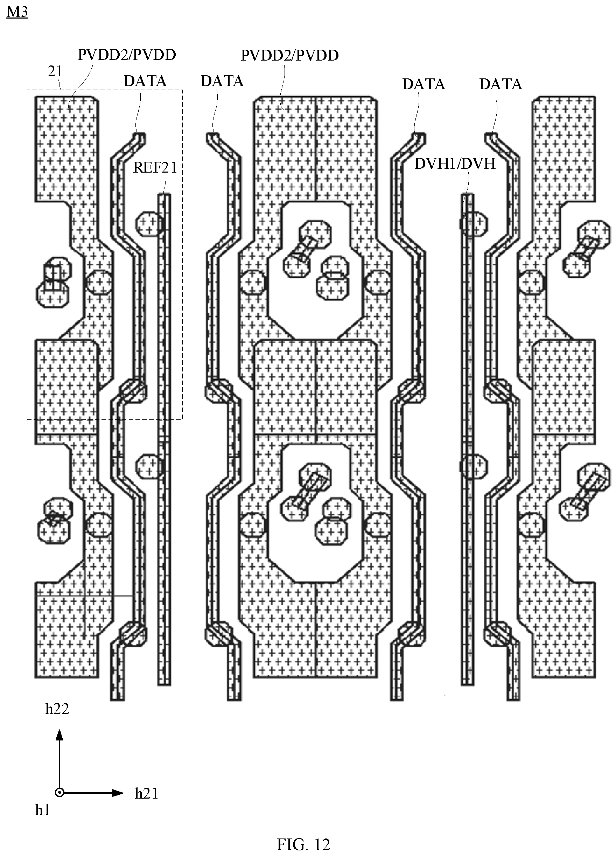

In an embodiment, as shown in FIG. 5, the display panel 100 further includes a second source-drain layer M3, and the second source-drain layer M3 is located on a side of the first source-drain layer M2 away from the substrate 1. Referring to FIG. 5 and FIG. 12, where FIG. 12 is a schematic top view of a second source-drain layer according to an embodiment of the present disclosure, the data line DATA can be provided in the second source-drain layer M3.

Exemplarily, the second source-drain layer M3 may include an alloy composed of one or more kinds of material such as aluminum (Al), platinum (Pt), palladium (Pd), silver (Ag), magnesium (Mg), gold (Au), nickel (Ni), neodymium (Nd), iridium (Ir), chromium (Cr), lithium (Li), calcium (Ca), molybdenum (Mo), titanium (Ti), tungsten (W), and copper (Cu), and may be formed into a single-layer or multi-layer structure. For example, the second source-drain layer M3 may be formed as a three-layer structure including Ti-Al-Ti, so as to reduce the resistance of traces provided in the second source-drain layer M3.

In an embodiment of the present disclosure, the first connection component 30 is located on a side of the second metal layer MC close to the substrate 1, and the data line DATA is located on a side of the second metal layer MC away from the substrate 1. Exemplarily, as shown in FIG. 6, in an embodiment of the present disclosure, the first connection component 30 may be provided in the first semiconductor layer SC1, and as shown in FIG. 12, and the data line DATA may be provided in the second source-drain layer M3.

When the pixel driving circuit 21 is in operation, after the charging of the first node N1 is completed and the data voltage provided by the data line DATA changes, if the coupling capacitance between the data line DATA and the first connection component 30 is relatively large, the voltage change on the data line DATA may affect the potential on the first connection component 30 through coupling. Since the first connection component 30 is electrically connected to the second node N2, the signal change on the first connection component 30 may affect the potential of the second node N2.

When the pixel driving circuit 21 operates, as shown in FIG. 3, after the fourth scan control signal line SP* is switched from an enable level to a non-enable level, since the threshold compensation transistor T4 is still in the conducting state under the action of the third scan control signal line S2N, if the potential of the second node N2 changes, the potential change of the second node N2 will be written into the first node N1 through the driving transistor T3 and the threshold compensation transistor T4, thereby affecting the conducting state of the driving transistor T3. For example, in the light-emitting phase, when the first light-emitting control transistor T1 and the second light-emitting control transistor T6 are turned on, a potential change of the first node N1 may cause the driving transistor T3 that should be in the off state to be turned on, causing the light-emitting element 22, which should not be emitting light, to emit light, and thus generating an unnecessary light-emitting phenomenon. For example, when black is written to a local region of the display panel, bright lines or dark lines may exist at the edge of the region, affecting the display effect of the display panel.

In the embodiment of the present disclosure, the first connection component 30 is located in the first semiconductor layer SC1, and the data line DATA may be provided on a side of the second metal layer MC away from the substrate 1, for example, as shown in FIG. 5, the data line DATA is provided in the second source-drain layer M3 having a larger distance from the first semiconductor layer SC1, thereby increasing a distance between the first connection component 30 and the data line DATA along the direction h1 perpendicular to the plane of the substrate 1, and thus reducing a coupling capacitance between the first connection component 30 and the data line DATA. When the data voltage transmitted by the data line DATA changes, the signal variation of the second node N2 can be weakened, thereby preventing the potential change of the second node N2 from affecting the potential change of the first node N1 through the driving transistor T3 and the threshold compensation transistor T4, avoiding affecting the light-emitting brightness of the light-emitting element 22 and thus improving the brightness uniformity of the display panel.

It should be noted that FIG. 2 only illustrates the pixel driving circuit 21 is configured as a "8T1C" structure including 8 transistors and 1 storage capacitor, where "T" represents a transistor, and "C" represents a storage capacitor. Those skilled in the art may also configure the pixel driving circuit 21 as other structures according to different design requirements, and the specific design of the pixel driving circuit 21 is not limited in this embodiment of the present disclosure.

In an embodiment, as shown in FIG. 4, the light-emitting control signal line EM is provided in the connection path between the bias adjustment transistor T8 and the driving transistor T3, that is, along the direction h1 perpendicular to the plane of the substrate 1, the first connection component 30 overlaps with the light-emitting control signal line EM. Based on this arrangement, the area of the pixel driving circuit 21 can be reduced, which is beneficial to improving the resolution of the display panel 100.

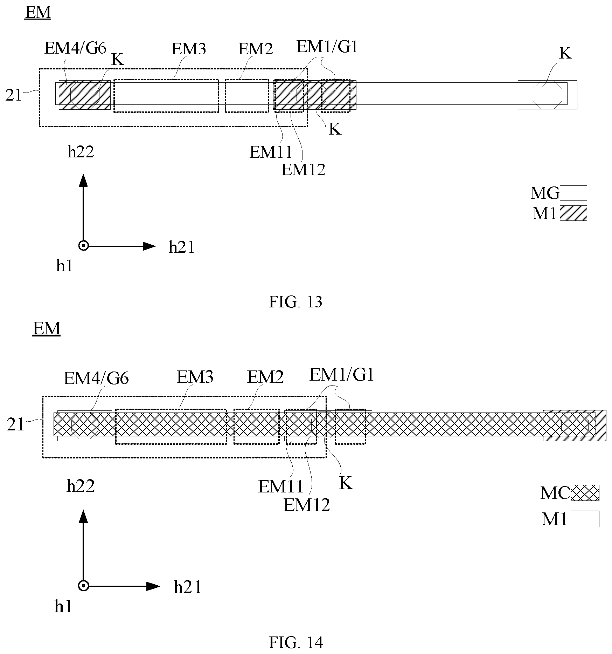

As shown in FIG. 4 and FIG. 13, where FIG. 13 is an enlarged schematic diagram of a light-emitting control signal line according to an embodiment of the present disclosure, the light-emitting control signal line EM extends along the first direction h21, and the light-emitting control signal line EM includes a first portion EM1 and a second portion EM2 electrically connected to each other. Along the direction h1 perpendicular to the plane of the substrate 1, the first portion EM1 overlaps with the channel T10 of the first light-emitting control transistor T1 (not shown in FIG. 13), and the second portion EM2 overlaps with the first connection component 30 (not shown in FIG. 13). Additionally, the first portion EM1 does not overlap with the first connection component 30 (not shown in FIG. 13), and the second portion EM2 does not overlap with the channel T10 of the first light-emitting control transistor T1 (not shown in FIG. 13). In this embodiment of the present disclosure, the first portion EM1 is multiplexed as the gate G1 of the first light-emitting control transistor T1.

As shown in FIG. 13, the first portion EM1 includes a first sub-portion EM11 and a second sub-portion EM12 which are stacked. Along the direction h1 perpendicular to the plane of the substrate 1, both the first sub-portion EM11 and the second sub-portion EM12 overlap with the channel T10 of the first light-emitting control transistor T1. The first sub-portion EM11 and the second sub-portion EM12 are electrically connected. Exemplarily, the first sub-portion EM11 and the second sub-portion EM12 are electrically connected through a via hole K passing through an insulating layer between the first sub-portion EM11 and the second sub-portion EM12.

In an embodiment of the present disclosure, as shown in FIG. 7 and FIG. 13, the first sub-portion EM11 may be provided in the first metal layer M1, and the second portion EM2 may be provided on a side of the first metal layer M1 away from the substrate 1.

In an embodiment of the present disclosure, the second portion EM2 is located on a side of the first metal layer M1 away from the substrate 1, and compared with an arrangement in which the second portion EM2 is provided in the first metal layer M1 or on a side of the first metal layer M1 close to the first semiconductor layer SC1, a distance between the second portion EM2 and the first connection component 30 can be increased, so that on one hand, the second portion EM2 and the first connection component 30 located in the first semiconductor layer SC1 can be prevented from overlapping to form a thin film transistor device, on the other hand, a coupling capacitance between the first connection component 30 and the second portion EM2 can be reduced, thereby reducing interference of a signal with high frequency change on the light-emitting control signal line EM on a potential on the first connection component 30 electrically connected to the second node N2.

Exemplarily, as shown in FIG. 10 and FIG. 13, the second portion EM2 may be located in the third metal layer MG, so as to increase a distance between the second portion EM2 and the first connection component 30, thereby avoiding the second portion EM2 and the first connection component 30 from overlapping to form a thin film transistor device, and reducing interference of a signal with high frequency change on the light-emitting control signal line EM on a potential on the first connection component 30 electrically connected to the second node N2.

Alternatively, as shown in FIG. 14, which is an enlarged schematic diagram of another light-emitting control signal line according to an embodiment of the present disclosure, the second portion EM2 is located in the second metal layer MC.

In this embodiment of the present disclosure, the second sub-portion EM12 may function to connect the first sub-portion EM11 and the second sub-portion EM2 located in different film layers. Exemplarily, the second sub-portion EM12 and the second portion EM2 may be provided in a same layer, that is, the second sub-portion EM12 and the second portion EM2 are integrally arranged to include line segments extending along the first direction h21, so as to reduce the number of film layers of the light-emitting control signal line EM and reduce the thickness of the display panel 100. Exemplarily, as shown in FIG. 10 and FIG. 13, the second sub-portion EM12 and the second portion EM2 are provided in the third metal layer MG. FIG. 14 illustrates that both the second sub-portion EM12 and the second portion EM2 are provided in the second metal layer MC.

As shown in FIG. 10, FIG. 13 and FIG. 14, the light-emitting control signal line EM further includes a third portion EM3. Along the direction h1 perpendicular to the plane of the substrate 1, the third portion EM3 does not overlaps with the channel T10 of the first light-emitting control transistor T1 and the first connection component 30. In this embodiment of the present disclosure, the third portion EM3 and the second portion EM2 are provided in a same layer or different layers.

FIG. 10 and FIG. 13 illustrate that both the third portion EM3 and the second portion EM2 are provided in the third metal layer MG. FIG. 14 illustrates that the third portion EM3 and the second portion EM2 are provided in the second metal layer MC. The third portion EM3 and the second portion EM2 provided in the same layer may be formed by the same material in a same patterning process, thereby simplifying the manufacturing process of the display panel. As shown in FIG. 10, FIG. 13 and FIG. 14, the third portion EM3 and the second portion EM2 may be connected to each other. When the third portion EM3 and the second portion EM2 are provided in a same layer, the third portion EM3 and the second portion EM2 may not include an interface therebetween, that is, the third portion EM3 and the second portion EM2 may be regarded as an integrated structure.

As shown in FIG. 10, FIG. 13 and FIG. 14, the light-emitting control signal line EM further includes an fourth portion EM4, along the direction h1 perpendicular to the plane of the substrate 1, the eighth portion EM4 overlaps with the channel T60 of the second light-emitting control transistor T6, and the fourth portion EM4 may be multiplexed as the gate G6 of the second light-emitting control transistor T6. As shown in FIG. 7, FIG. 10, FIG. 13 and FIG. 14, the fourth portion EM4 includes two stacked portions, and the two portions are electrically connected through a via hole K passing through the insulating layer therebetween. In an embodiment, as shown in FIG. 10, one portion EM42 in the fourth portion EM4 may be provided in the same layer as the second portion EM2 and the second sub-portion EM12, and as shown in FIG. 7, another portion EM41 in the fourth portion EM4 may be provided in the same layer as the first sub-portion EM11. The third portion EM3 may be configured to be electrically connected to the fourth portion EM4 and the second portion EM2.

When the first semiconductor layer SC1 is provided, for example, as shown in FIG. 6, the pixel driving circuit 21 includes a connection node N4. The connection node N4 electrically connects the bias adjustment transistor T8, the first light-emitting control transistor T1 and the driving transistor T3. In an embodiment, the connection node N4 electrically connects the channel T80 of the bias adjustment transistor T8, the channel T10 of the first light-emitting control transistor T1, and the channel T30 of the driving transistor T3.

As shown in FIG. 6, the channel T80 of the bias adjustment transistor T8 and the channel T10 of the first light-emitting control transistor T1 are respectively located on two sides of the connection node N4. The channel T80 of the bias adjustment transistor T8 and the channel T10 of the first light-emitting control transistor T1 are respectively located on two sides of the connection node N4, which may be understood as that the channel T80 of the bias adjustment transistor T8 and the channel T10 of the first light-emitting control transistor T1 are located on two sides along a first reference line passing through the connection node N4, and the first reference line passes through the connection node N4 and extends along the first direction h21. In an embodiment, as shown in FIG. 6, the first semiconductor layer SC1 includes a first semiconductor sub-portion X1 extending along the second direction h22. The first semiconductor sub-portion X1 includes the channel T80 of the bias adjustment transistor T8, the channel T10 of the first light-emitting control transistor T1, and the connection node N4. The first connection component 30 includes a first line segment 301 extending along the first direction h21 and a second line segment 302 extending in the second direction h22. The first line segment 301 electrically connects the connection node N4 and the second line segment 302, and the second line segment 302 electrically connects the first line segment 301 and the channel T30 of the driving transistor T3.

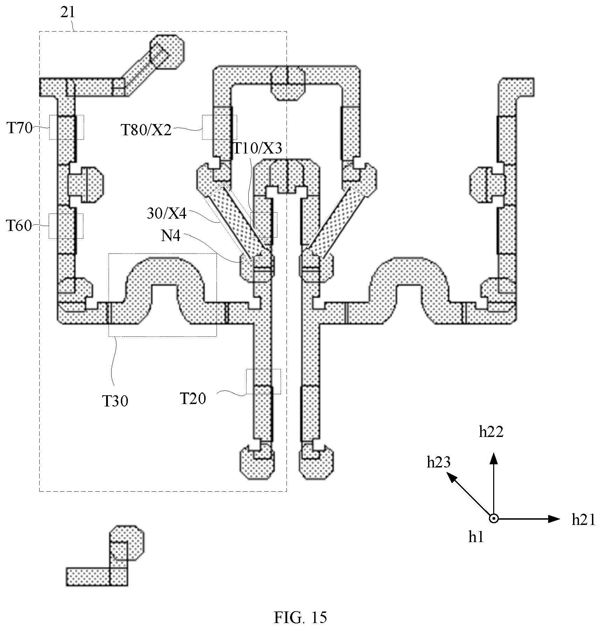

Alternatively, as shown in FIG. 15, which is a schematic top view of another first semiconductor layer according to an embodiment of the present disclosure, the channel T80 of the bias adjustment transistor T8 and the channel T10 of the first light-emitting control transistor T1 are located on a same side of the connection node N4. The channel T80 of the bias adjustment transistor T8 and the channel T10 of the first light-emitting control transistor T1 are located on the same side of the connection node N4, which may be understood that the channel T80 of the bias adjustment transistor T8 and the channel T10 of the first light-emitting control transistor T1 are located on the same side of the first reference line, which passes through the connection node N4 and extends along the first direction h21.

As shown in FIG. 15, the channel T80 of the bias adjustment transistor T8 is electrically connected to the connection node N4 through the first connection component 30, and the connection node N4 is electrically connected to the channel T30 of the driving transistor T3.

In an embodiment, as shown in FIG. 15, the first semiconductor layer SC1 includes a second semiconductor sub-portion X2, a third semiconductor sub-portion X3, and a fourth semiconductor sub-portion X4. The second semiconductor sub-portion X2 includes the channel T80 of the bias adjustment transistor T8. The third semiconductor sub-portion X3 includes the channel T10 of the first light-emitting control transistor T1. The fourth semiconductor sub-portion X4 includes the first connection component 30.

Exemplarily, as shown in FIG. 15, the second semiconductor sub-portion X2 and the third semiconductor sub-portion X3 are parallel, and both intersect with and are connected to the first connection component 30. FIG. 15 illustrates that both the second semiconductor sub-portion X2 and the third semiconductor sub-portion X3 extend along the second direction h22.

In an embodiment, as shown in FIG. 15, part of the first connection component 30 extends along the third direction h23, and the third direction h23 intersects with both the first direction h21 and the second direction h22.

Exemplarily, as shown in FIG. 6 and FIG. 15, in this embodiment of the present disclosure, the channel T70 of the second reset transistor T7 and the channel T80 of the bias adjustment transistor T8 may be arranged along the first direction h21. The channel T60 of the second light-emitting control transistor T6 and the channel T10 of the first light-emitting control transistor T1 are arranged along the first direction h21.

In an embodiment, as shown in FIG. 6 and FIG. 15, along the first direction h21, the channel T60 of the second light-emitting control transistor T6 and the channel T10 of the first light-emitting control transistor T1 are located on two sides of the channel T30 of the driving transistor T3, respectively. Along the second direction h22, the channel T20 of the data writing transistor T2 and the channel T80 of the bias adjustment transistor T8 are located on both sides of the channel T30 of the driving transistor T3.

Exemplarily, as shown in FIG. 4, the first power supply voltage line PVDD includes a first power supply voltage sub-line PVDD1 extending along the first direction h21.

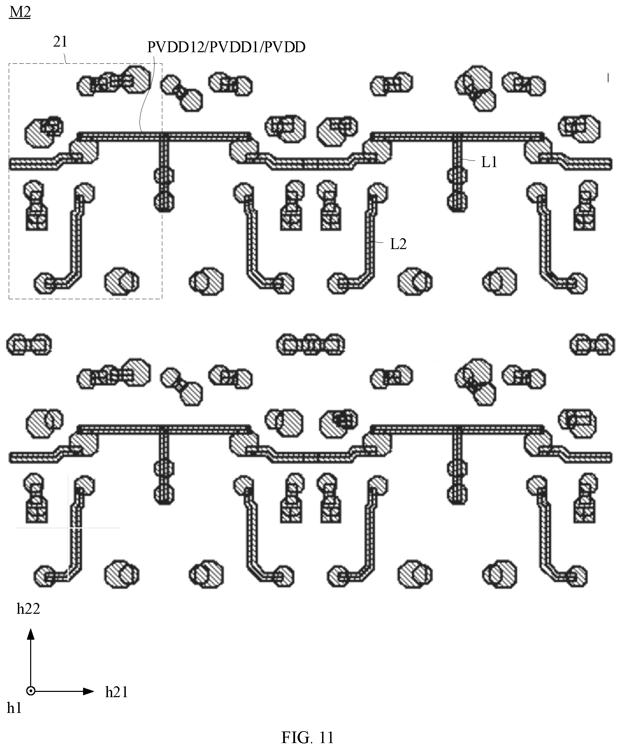

Referring to FIG. 8 and FIG. 11, where FIG. 11 is a schematic top view of a first source-drain layer according to an embodiment of the present disclosure, the first power supply voltage sub-line PVDD1 includes a first sub-section PVDD11 and a second sub-section PVDD12 that are stacked. The first sub- section PVDD11 is electrically connected to the second sub-section PVDD12, thereby reducing a resistance of the first power supply voltage sub-line PVDD1. As shown in FIG. 8, the first sub-section PVDD11 is located in the second metal layer MC, and the first sub-section PVDD11 is electrically connected to the second plate C2 of the storage capacitor Cst, so as to provide the first power supply sub-voltage Vpvdd to the second plate C2 of the storage capacitor Cst. Exemplarily, as shown in FIG. 11, the second sub-section PVDD12 of the first power supply voltage sub-line PVDD1 is located in the first source-drain layer M2.

Exemplarily, along the direction h1 perpendicular to the plane of the substrate 1, the second sub-section PVDD12 at least partially overlaps with the first sub-section PVDD11.

In an embodiment, as shown in FIG. 11, the first source-drain layer M2 further includes a first connection portion L1 electrically connected to the second sub-section PVDD12 and the first sub-section PVDD11.

Exemplarily, as shown in FIG. 11, the first connecting portion L1 extends from the second sub-section PVDD12 to a side away from the second sub-section PVDD12 along the second direction h22. An orthographic projection of the first connection portion L1 onto the plane of the substrate 1 is located between two adjacent pixel circuits 21.

As shown in FIG. 4, the first power supply voltage line PVDD further includes a second power supply voltage sub-line PVDD2 extending along the second direction h22, and the second power supply voltage sub-line PVDD2 is electrically connected to the first power supply voltage sub-line PVDD1. The arrangement of the second power supply voltage sub-line PVDD2 and the first power supply voltage sub-line PVDD1 can make the first power supply voltage line PVDD form a grid structure, thereby reducing the voltage drop of the first power supply voltage signal Vpvdd during transmission, and thus being beneficial to improving the display uniformity of the sub-pixels at different positions.

In an embodiment, the second power supply voltage sub-line PVDD2 and the first power supply voltage sub-line PVDD1 are provided in different layers, and FIG. 12 illustrates that the second power supply voltage sub-line PVDD2 is located in the second source-drain layer M3.

As shown in FIG. 4, along the direction h1 perpendicular to the plane of the substrate 1, the first scan control signal line SP* overlaps with the channel T80 of the bias adjustment transistor T8. The portion of the first scan control signal line SP* overlapping with the channel T80 of the bias adjustment transistor T8 is multiplexed as the gate G8 of the bias adjustment transistor T8. FIGS. 4 and 7 illustrate that the first scan control signal line SP* is located in the first metal layer M1.

Exemplarily, as shown in FIG. 4, along the direction h1 perpendicular to the plane of the substrate 1, the first scanning control signal line SP* at least partially overlaps with the bias adjustment signal line DVH to reduce the area of the pixel driving circuit 21 and improve the resolution of the display panel 100.

FIG. 4 and FIG. 7 illustrate that the first scan control signal line SP* is located in the first metal layer M1, and FIG. 4 and FIG. 10 illustrate that the bias adjustment signal line DVH includes a second bias adjustment signal sub-line DVH2 extending along the first direction h21, the second bias adjustment signal sub-line DVH2 is located in the third metal layer MG, and the first scan control signal line SP* at least partially overlap with the second bias adjustment signal sub-line DVH2 along the direction h1 perpendicular to the plane of the substrate 1.

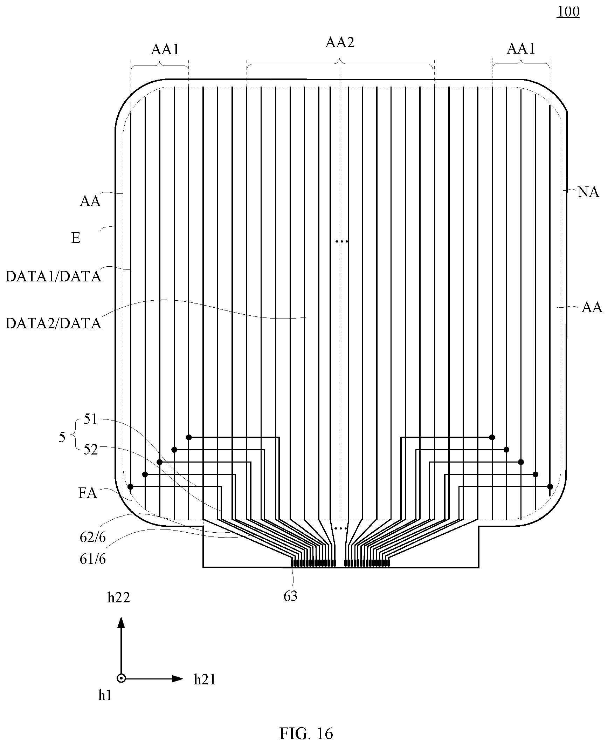

Exemplarily, as shown in FIG. 16, which is a simplified schematic diagram of another display panel according to an embodiment of the present disclosure.

The display region AA includes a first display region AA1 and a second display region AA2. Along the first direction h21, the first display region AA1 is located on at least one side of the second display region AA2. As shown in FIG. 16, the display region AA includes two first display regions AA1. Along the first direction h21, the two first display regions AA1 are located on two sides of the second display region AA2. That is, the first display region AA1 is closer to the edge E of the display panel 100 than the second display region AA2.

In an embodiment of the present disclosure, the data line DATA includes a first data line DATA1 located in the first display region AA1 and a second data line DATA2 located in the second display region AA2.

As shown in FIG. 16, the display panel 100 further includes a non-display region NA at least partially surrounding the display region AA. The non-display region NA includes a fan-out region FA located on a side of the display region AA along the second direction h22. The fan-out region FA includes a plurality of fan-out traces 6. The data line DATA is connected to the fan-out traces 6.

As shown in FIG. 16, the display region AA further includes a connecting line 5. Exemplarily, the fan-out traces 6 include a first fan-out trace 61 and a second fan-out trace 62. The first data line DATA1 is connected to the first fan-out trace 61 through the connection line 5. The second data line DATA2 may be directly electrically connected to the second fan-out trace 62. The first fan-out trace 61 and the second fan-out trace 62 are electrically connected to pins 63.

As shown in FIG. 16, the connection line 5 includes a first connection line 51 and a second connection line 52 electrically connected to each other. The first connection line 51 is electrically connected to the first data line DATA1. The first connection line 51 extends along the first direction h21. The second connection line 52 extends along the second direction h22.

In an embodiment of the present disclosure, the first data line DATA1 in the first display region AA1 may be electrically connected to the first fan-out trace 61 through the connection line 5, and the second data line DATA2 in the second display region AA2 may be directly electrically connected to the second fan-out trace 62. Based on this arrangement, it is equivalent to arranging some fan-out traces in the display area (FIAA), which can reduce the space occupied by the fan-out traces 6, thereby reducing the area of the fan-out region FA, thus decreasing the area ratio of the non-display region NA in the display panel, while increasing the area ratio of the display region AA in the display panel, that is, improving the screen-to-body ratio of the display panel, and enhancing the users' experience.

Additionally, as shown in FIG. 16, the second connection line 52 is located on a side of the first data line DATA1 connected thereto close to the second display region AA2. Based on this arrangement, the first fan-out trace 61 that needs to be connected to the first data line DATA1 can be led out from a position in the display region AA close to the middle region, thereby preventing the first fan-out trace 61 connected to the first data line DATA1 in the first display region AA1 from being led out from a region in the frame of the display panel 100 close to the corner, thus being beneficial to reducing the width of the frame at the corner of the display panel 100 and optimizing the visual effect of the display panel.

In this embodiment of the present disclosure, the layer positions of the first connection line 51 and the second connection line 52 may be adjusted according to the arrangement of different film layers in the display panel 100. For example, in an embodiment of the present disclosure, the first connection line 51 and the second connection line 52 may be provided in different layers, and are electrically connected by using the via hole. Alternatively, in an embodiment of the present disclosure, the first connection line 51 and the second connection line 52 may be provided in a same layer.

When the first connection line 51 and the second connection line 52 are provided in different layers, for example, in this embodiment of the present disclosure, the second connection line 52 and the first connection line 51 may be located in two adjacent conductive layers, thereby reducing the difficulty in providing the via hole, which is configured to electrically be connected to the first connection line 51 and the second connection line 52. The two adjacent conductive layers refer to two closest conductive layers in the display panel 100. For example, the first source-drain layer M2 and the second source-drain layer M3 in FIG. 5 are two adjacent conductive layers.

When the first connection line 51 and the second connection line 52 are provided in different layers, in an embodiment of the present disclosure, the second connection line 52 may be located on a side of the first connection line 51 away from the substrate.

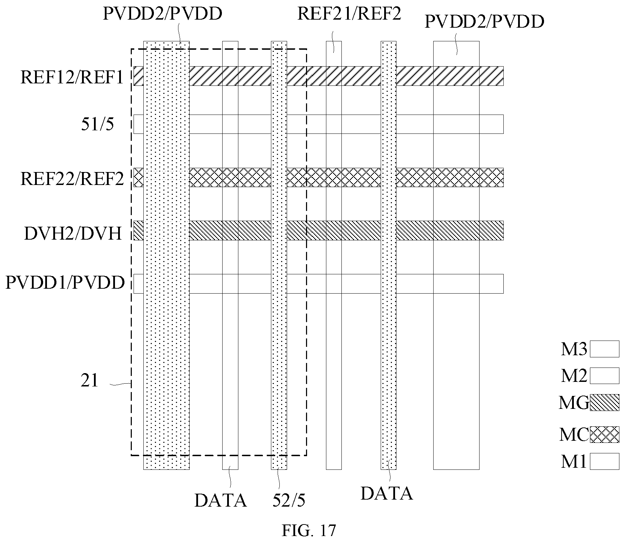

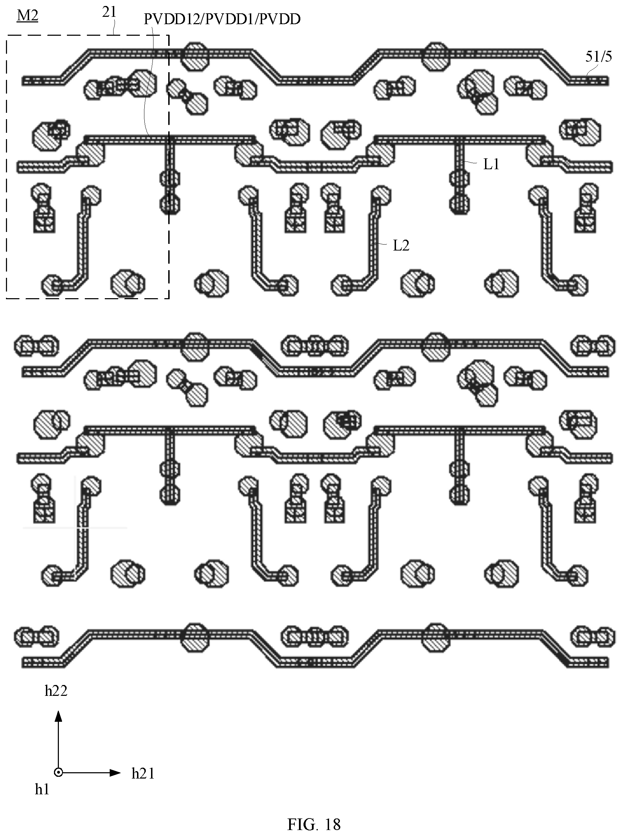

Exemplarily, referring to FIG. 17 and FIG. 18, where FIG. 17 is a schematic wiring diagram of another display panel according to an embodiment of the present disclosure, and FIG. 18 is a schematic top view of another first source-drain layer according to an embodiment of the present disclosure, the first connection line 51 is located in the first source-drain layer M2.

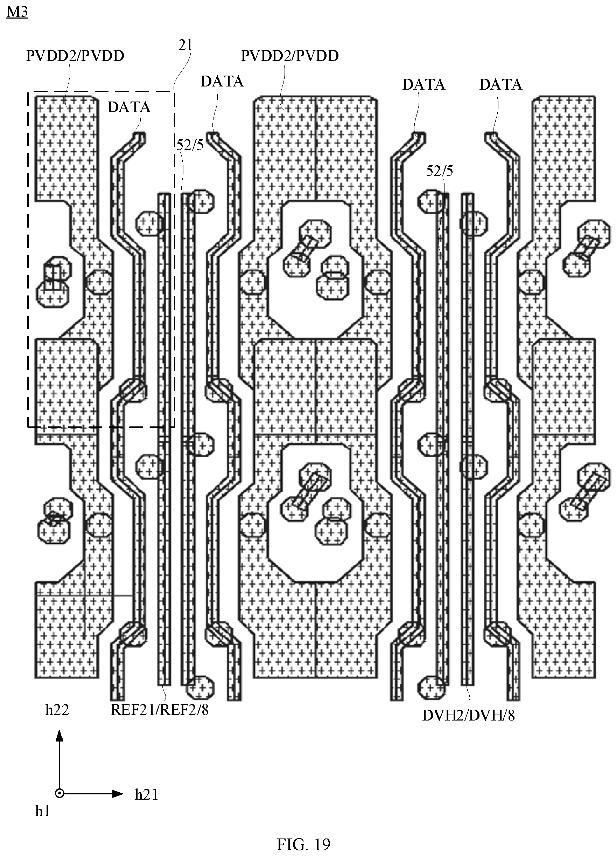

Referring to FIG. 17 and FIG. 19, where FIG. 19 is a schematic top view of another second source-drain layer according to an embodiment of the present disclosure, and the second connection line 52 may be located in the second source-drain layer M3.

In an embodiment of the present disclosure, the second connection line 52 is located on a side of the first connection component 30 away from the substrate 1.

Exemplarily, in an embodiment of the present disclosure, the second connection line 52 may be located on a side of the second metal layer MC away from the substrate 1, for example, as shown in FIG. 19, the second connection line 52 is provided in the second source-drain layer M3 having a large distance from the first connection component 30, which may increase the distance between the first connection component 30 and the second connection line 52 along the direction h1 perpendicular to the plane of the substrate 1, thereby reducing the coupling capacitance between the first connection component 30 and the second connection line 52. When the data voltage transmitted by the second connection line 52 changes, the signal variation of the second node N2 can be weakened, thereby preventing the potential change of the second node N2 from affecting the potential change of the first node N1 through the driving transistor T3 and the threshold compensation transistor T4, avoiding affecting the light-emitting brightness of the light-emitting element 22 and thus improving the brightness uniformity of the display panel.

Exemplarily, in an embodiment of the present disclosure, along the direction h1 perpendicular to the plane of the substrate 1, one of the data line DATA and the second connection line 52 at least partially overlaps with the first connection component 30. Based on this arrangement, the area of the pixel driving circuit 21 can be reduced, which is beneficial to improving the resolution of the display panel 100. As shown in FIG. 17, along the direction h1 perpendicular to the plane of the substrate 1, the data line DATA overlaps with the first connection component 30. In other arrangements, the relative position of the data line DATA and the second connection line 52 may be adjusted, and the second connection line 52 is configured to at least partially overlap with the first connection component 30, which will not be illustrated herein again.

Exemplarily, in an embodiment of the present disclosure, along the first direction h21, a fixed signal line and the second connection line 52 are located between two adjacent data lines DATA, where the fixed signal line is configured to transmit one of the first reset voltage Vref1, the second reset voltage Vref2 and the bias adjustment voltage Vdvh. For example, as shown in FIG. 19, two fixed signal lines 8 are shown, one transmitting the second reset voltage Vref2 and the other transmitting the bias adjustment voltage Vdvh, that is, one fixed signal line 8 is the second reset signal line REF2, and the other fixed signal line 8 is the bias adjustment signal line DVH.

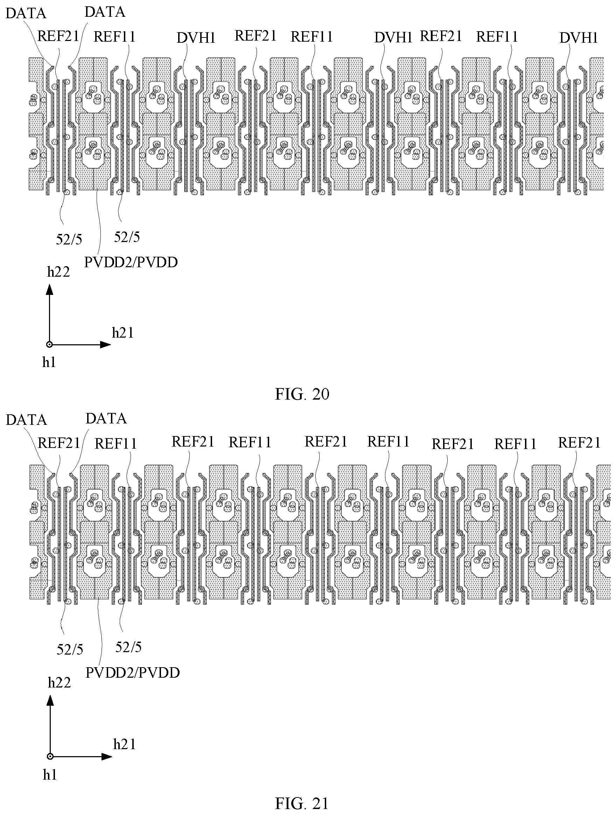

Exemplarily, as shown in FIG. 20, which is a simplified schematic diagram of another display panel according to an embodiment of the present disclosure, the first reset signal line REF1 includes a first reset signal sub-line REF11 extending along the second direction h22. The second reset signal line REF2 includes a second reset signal sub-line REF21 extending along the second direction h22. The bias adjustment signal line DVH includes a first bias adjustment signal sub-line DVH1 extending along the second direction h22. The fixed signal line includes any one or more of the first reset signal sub-line REF11, the second reset signal sub-line REF21, and the first bias adjustment signal sub-line DVH1.

In an embodiment of the present disclosure, any two or three of the first reset signal sub-line REF11, the second reset signal sub-line REF21 and the first bias adjustment signal sub-line DVH1 are alternately arranged along the first direction h21.

As shown in FIG. 20, the three are arranged alternately in the order of the second reset signal sub-line REF21, the first reset signal sub-line REF11 and the first bias adjustment signal sub-line DVH1. Of course, the three can also be arranged alternately in other orders of the first reset signal sub-line REF11, the first bias adjustment signal sub-line DVH, the second reset signal sub-line REF21 and the like, which will not be illustrated herein again. Based on this arrangement, the fixed signal lines transmitting different signals can be uniformly dispersed in the display panel as much as possible, and the voltage drop of various fixed signals can be reduced in limited space.

As shown in FIG. 21, which is a simplified schematic diagram of another display panel according to an embodiment of the present disclosure, the first reset signal sub-line REF11 and the second reset signal sub-line REF21 are alternately arranged along the first direction h21.

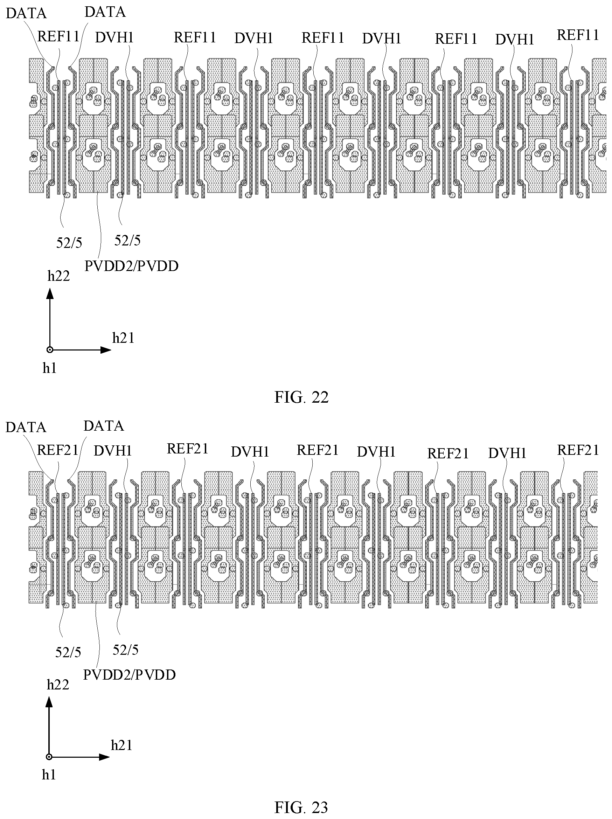

As shown in FIG. 22, which is a simplified schematic diagram of another display panel according to an embodiment of the present disclosure, the first reset signal sub-line REF11 and the first bias adjustment signal sub-line DVH1 are alternately arranged along the first direction h21.

As shown in FIG. 23, FIG. 23 is a simplified schematic diagram of another display panel according to an embodiment of the present disclosure, the second reset signal sub-line REF21 and the first bias adjustment signal sub-line DVH1 are alternately arranged along the first direction h21.

Exemplarily, as shown in FIG. 4 and FIG. 17, the first reset signal line REF1 further includes a third reset signal sub-line REF12 electrically connected to the first reset signal sub-line REF11, and the third reset signal sub-line REF12 extends along the first direction h21. Based on this arrangement, the first reset signal line REF1 may be formed into a grid structure, the transmission path of the first reset voltage Vref1 may be increased, the voltage drop of the first reset voltage Vref1 in the transmission process may be reduced, the potential consistency of the first reset voltage Vref1 received by the pixel driving circuit 21 at different positions may be improved, thereby making the display effects of the light-emitting elements 22 at different positions to be consistent.

As shown in FIG. 4 and FIG. 17, the second reset signal line REF2 further includes a fourth reset signal sub-line REF22 electrically connected to the second reset signal sub-line REF21, and the fourth reset signal sub-line REF22 extends along the first direction h21. Based on this arrangement, the second reset signal line REF2 may be formed into a grid structure, the transmission path of the second reset voltage Vref2 may be increased, the voltage drop of the second reset voltage Vref2 in the transmission process may be reduced, the potential consistency of the second reset voltage Vref2 received by the pixel driving circuits at different positions can be improved, thereby making the display effects of the light-emitting elements 22 at different positions to be consistent.

As shown in FIG. 4 and FIG. 17, the bias adjustment signal line DVH includes a second bias adjustment signal sub-line DVH2 electrically connected to the first bias adjustment signal sub-line DVH1, and the second bias adjustment signal sub-line DVH2 extends along the first direction h21. Based on this arrangement, the bias adjustment signal line DVH can be formed into a grid structure, the transmission path of the bias adjustment voltage Vdvh may be increased, the voltage drop of the bias adjustment voltage Vdvh in the transmission process may be reduced, and the corresponding fixed signals received by the pixel driving circuits 21 at different positions may be improved, such as, the potential consistency of the first reset voltage Vref1, the second reset voltage Vref2 and the bias adjustment voltage Vdvh may be improved, thereby making the display effects of the light-emitting elements 22 at different positions to be consistent.

Exemplarily, in an embodiment of the present disclosure, the third reset signal sub-line REF12 and the first reset signal sub-line REF11 are provided in different layers. The fourth reset signal sub-line REF22 and the second reset signal sub-line REF21 are provided in different layers. The second bias adjustment signal sub-line DVH2 and the first bias adjustment signal sub-line DVH1 are provided in different layers.

In an embodiment of the present disclosure, at least two of the first reset signal sub-line REF11, the second reset signal sub-line REF21 and the first bias adjustment signal sub-line DVH1 may be provided in a same layer.

In an embodiment, as shown in FIG. 7, the third reset signal sub-line REF12 may be located in the first metal layer M1, the first reset signal sub-line REF11 may be located in the second source-drain layer M3, and the third reset signal sub-line REF12 and the first reset signal sub-line REF11 are electrically connected to the second source-drain layer M3 through the via hole.

Exemplarily, as shown in FIG. 8, the fourth reset signal sub-line REF22 may be located in the second metal layer MC, and as shown in FIG. 12 and FIG. 19, the second reset signal sub-line REF21 may be located in the second source-drain layer M3, and the fourth reset signal sub-line REF22 may be electrically connected to the second reset signal sub-line REF21d through a via hole.

In an embodiment, as shown in FIG. 10, the second bias adjustment signal sub-line DVH2 may be located in the third metal layer MG, and as shown in FIG. 12 and FIG. 19, the first bias adjustment signal sub-line DVH1 may be located in the second source-drain layer M3, and the second bias adjustment signal sub-line DVH2 may be electrically connected to the first bias adjustment signal sub-line DVH1 through a via hole.

In an embodiment of the present disclosure, at least two of the data line DATA, the second connection line 52, the first reset signal sub-line REF11, the second reset signal sub-line REF21 and the first bias adjustment signal sub-line DVH1 are provided in a same layer. Based on this arrangement, the number of film layers in the display panel can be reduced, the manufacturing process of the display panel can be simplified, and the thickness of the display panel can be reduced. As shown in FIG. 19, the second power supply voltage sub-line PVDD2, the data line DATA, the second connection line 52, the second reset signal sub-line REF21 and the first bias adjustment signal sub-line DVH1 are all provided in the second source-drain layer M3.

Exemplarily, as shown in FIG. 19, along the first direction h21, the second connection line 52 is located between two adjacent data lines DATA.

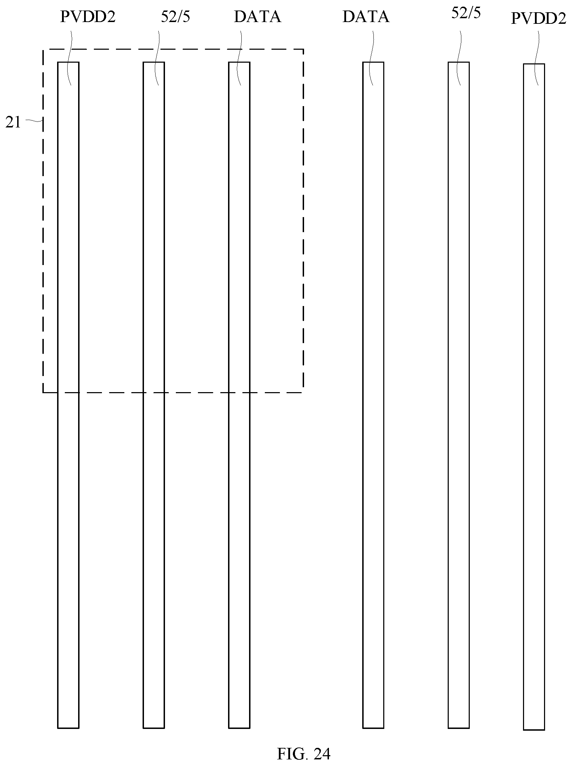

Alternatively, as shown in FIG. 24, which is a simplified schematic diagram of another display panel according to an embodiment of the present disclosure, the relative position relationship between the data line DATA and the second connection lines 52 may be adjusted, so that the data line DATA is located between two adjacent second connection lines 52 along the first direction h21. The second power supply voltage sub-line PVDD2 is located on a side of the second connection line 52 away from the data line DATA. Exemplarily, as shown in FIG. 24, along the direction perpendicular to the plane of the substrate, the second connection line 52 at least partially overlaps with the pixel driving circuit 21.

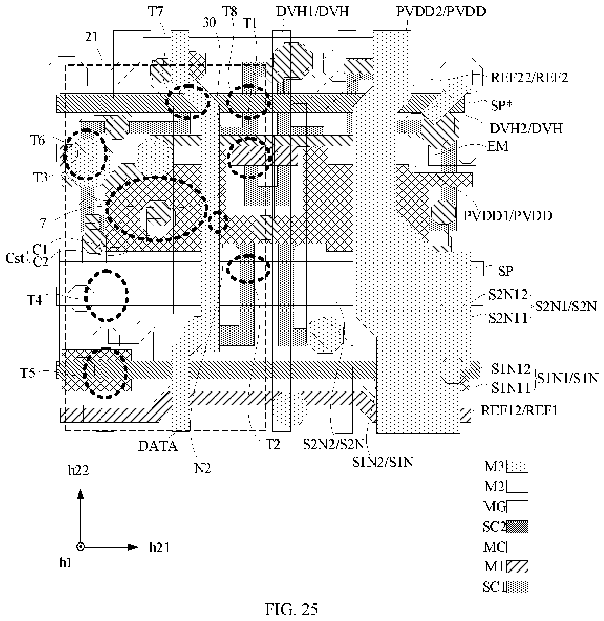

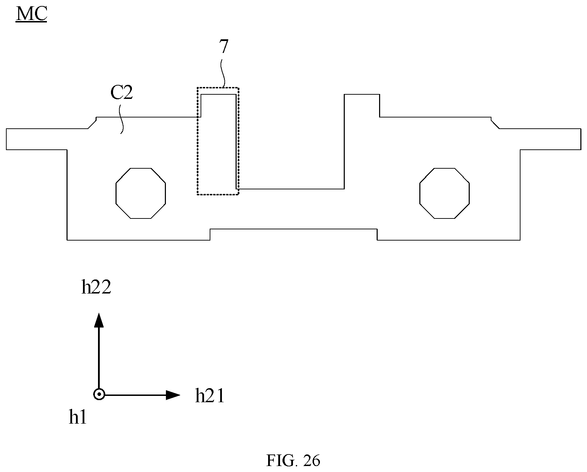

Exemplarily, as shown in FIG. 25 and FIG. 26, where FIG. 25 is a schematic trace diagram of another pixel driving circuit according to an embodiment of the present disclosure, and FIG. 26 is a schematic diagram of a second plate and a shielding component in FIG. 25, the display panel further includes a shielding component 7, and the shielding component 7 receives a constant signal.

In an embodiment of the present disclosure, as shown in FIG. 25, along the direction perpendicular to the plane of the substrate 1, the shielding component 7 is located between the data line DATA and the first connection component 30, and the shielding component 7 at least partially overlaps with the data line DATA and the first connection component 30. In this embodiment of the present disclosure, the shielding component 7 may further weaken the coupling capacitance between the data line DATA and the first connection component 30, thereby reducing the interference of the signal change on the data line DATA on the signal on the first connection component 30, which is beneficial to improving the potential stability of the second node N2, thereby improving the potential stability of the first node N1 and thus improving the display uniformity of the display panel.

Alternatively, when the relative position relationship between the data line DATA and the second connection line 52 is adjusted, in an embodiment of the present disclosure, the shielding component may be located between the second connection line and the first connection component, and the shielding component at least partially overlaps with the second connection line and the first connection component along the direction perpendicular to the plane of the substrate. Based on this arrangement, the shielding component can weaken the coupling capacitance between the second connection line and the first connection component, thereby reducing the interference of the signal change on the second connection line on the signal on the first connection component, thereby improving the potential stability of the second node N2, further improving the potential stability of the first node N1, and thus improving the display uniformity of the display panel.

In an embodiment, the constant signal transmitted by the shielding component 7 includes any one of the first power supply voltage Vpvdd, the first reset voltage Vref1, the second reset voltage Vref2, and the bias adjustment voltage Vdvh.

Exemplarily, as shown in FIG. 25 and FIG. 26, the shielding component 7 is electrically connected to the second plate C2, so that the shielding component 7 receives the first supply voltage Vpvdd through the second plate C2.

Exemplarily, as shown in FIG. 25 and FIG. 26, the shielding component 7 and the second plate C2 are provided in the second metal layer MC. The shielding component 7 protrudes from the second plate C2 towards a side away from the second plate C2 along the second direction h22.

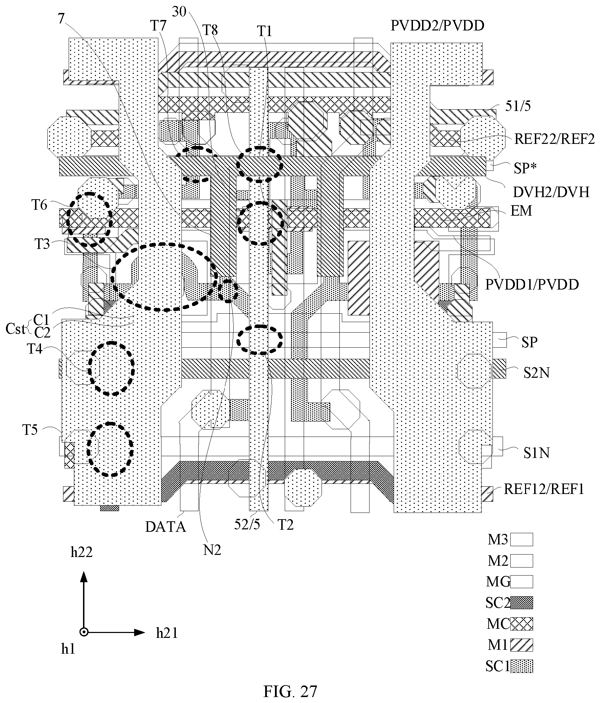

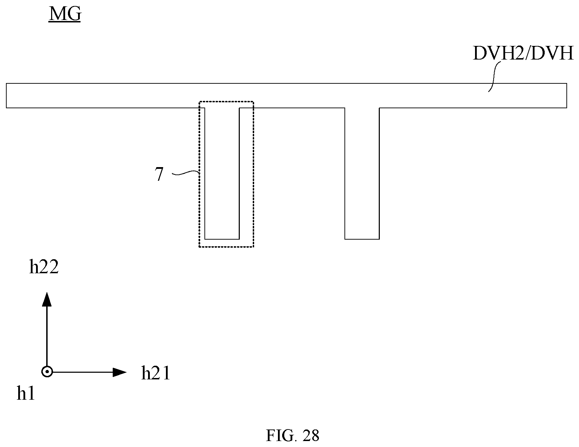

Alternatively, as shown in FIG. 27 and FIG. 28, where FIG. 27 is a schematic trace diagram of another pixel driving circuit according to an embodiment of the present disclosure, and FIG. 28 is a schematic diagram of a shielding component and a second bias adjustment signal sub-line in FIG. 27, the shielding component 7 is electrically connected to the bias adjustment signal line DVH, so that the shielding component 7 receives the bias adjustment voltage Vdvh. In FIG. 27, both the shielding component 7 and the second bias adjustment signal sub-line are provided in the third metal layer MG, while both the second sub-portion and the second portion of the light-emitting control signal line EM are located in the second metal layer MC.

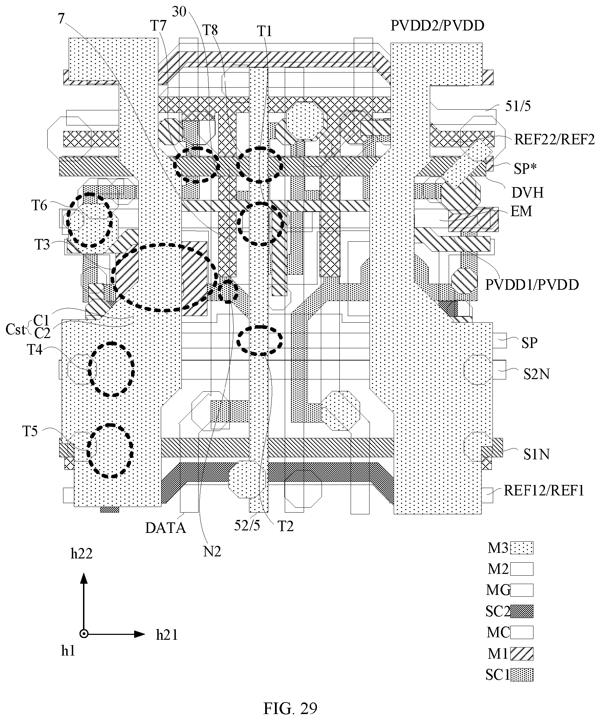

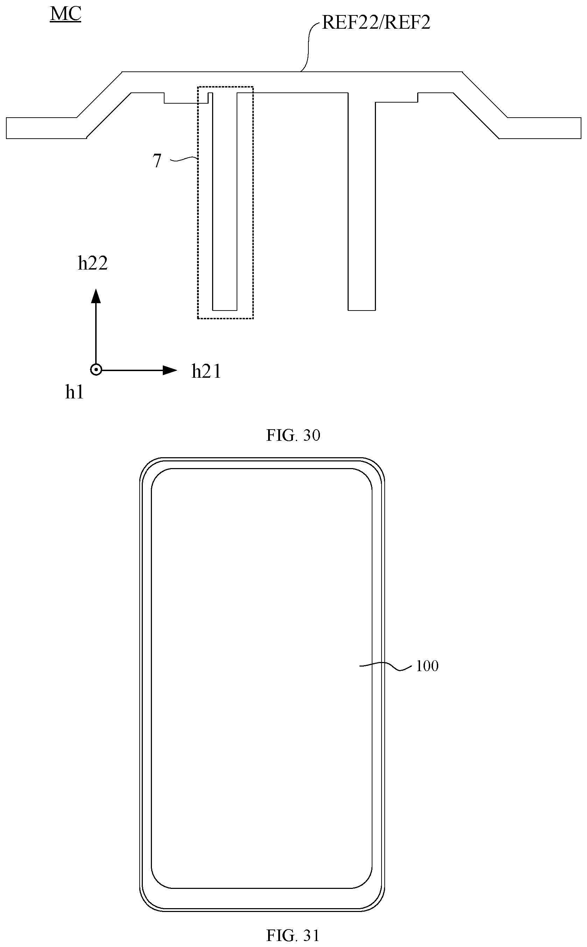

Alternatively, in an embodiment of the present disclosure, the shielding component 7 may be electrically connected to the first reset signal line REF1 or the second reset signal line REF2. As shown in FIG. 29 and FIG. 30, where FIG. 29 is a schematic trace diagram of another pixel driving circuit according to an embodiment of the present disclosure, and FIG. 30 is a schematic diagram of a shielding component and a fourth reset signal sub-line in FIG. 29, the shielding component 7 is electrically connected to the fourth reset signal sub-line REF22 in the second reset signal line REF2, so that the shielding component 7 receives the bias second reset voltage Vref2.

Exemplarily, as shown in FIG. 4, FIG. 17, FIG. 25 and FIG. 27, two adjacent pixel driving circuits 21 along the first direction h21 may be symmetrically arranged, and a symmetry line extends along the second direction h22. The transistors in the adjacent pixel driving circuits 21 along the first direction h21 are symmetrically arranged about the symmetry line, for example, the first light-emitting control transistors T1 in the adjacent pixel driving circuits 21 along the first direction h21 are symmetrical about the symmetry line. Based on this arrangement, some transistors in two adjacent pixel driving circuits 21 may share one via hole to be electrically connected to the corresponding signal line, thereby simplifying the structure of the pixel driving circuit and thus being beneficial to reducing the area of the pixel driving circuit. For example, as shown in FIG. 4, the bias adjustment transistors T8 in two adjacent pixel driving circuits 21 along the first direction h21 may be electrically connected to the bias adjustment signal line DVH through a same via hole.

Exemplarily, as shown in FIG. 4, FIG. 17, FIG. 25, and FIG. 27, an orthographic projection of the fourth reset signal sub-line REF22 onto the plane of the substrate 1, an orthographic projection of the first scan control signal line SP* onto the plane of the substrate 1, an orthographic projection of the light-emitting control signal line EM onto the plane of the substrate 1, an orthographic projection of the first power supply voltage sub-line PVDD1 onto the plane of the substrate 1, an orthographic projection of the fourth scan control signal line SP onto the plane of the substrate 1, an orthographic projection of the third scan control signal line S2N onto the plane of the substrate 1, an orthographic projection of the second scan control signal line S1N onto the plane of the substrate 1, and an orthographic projection of the third reset signal sub-line REF12 onto the plane of the substrate 1 are sequentially arranged along the second direction h22.

Based on the same inventive concept, an embodiment of the present disclosure further provides a display device, as shown in FIG. 31, which is a schematic diagram of a display device according to an embodiment of the present disclosure, the display device includes the above-mentioned display panel 100. The specific structure of the display panel 100 has been described in detail in the foregoing embodiments, and details are not described herein again. It is understandable that, the display device shown in FIG. 31 is merely illustrative, and the display device can be any electronic device having a display function such as a mobile phone, a vehicle-mounted display screen, a tablet computer, a notebook computer, an electronic paper book, or a television.

The above description merely illustrates some preferred embodiments of the present disclosure and is not intended to limit the present disclosure, and any modification, equivalent substitution, improvement and the like made within a spirit and a principle of the present disclosure shall fall with the scope of the present disclosure.

Finally, it should be noted that, the above embodiments are merely used to illustrate the technical solutions of the present disclosure, but not to limit the same. Although the present disclosure has been described in detail with reference to the above embodiments, those skilled in the art should understand that the technical solutions described in the above embodiments of the present disclosure may still be modified, or some or all of the technical features may be equivalently replaced. These modifications or substitutions do not make the essence of the corresponding technical solutions depart from the scope of the technical solutions in the embodiments of the present disclosure.

## Claims

1. A display panel, **characterized by** comprising:
a substrate;
a data line and a pixel driving circuit that are located on a side of the substrate, wherein the pixel driving circuit comprises a driving transistor, a bias adjustment transistor and a first connection component, a gate of the driving transistor is electrically connected to a first node, a first electrode of the driving transistor is electrically connected to a second node, a second electrode of the driving transistor is electrically connected to a third node, and the first connection component electrically connects the bias adjustment transistor and the second node; and
a first semiconductor layer and a first metal layer, wherein the first semiconductor layer and the first metal layer are sequentially stacked along a direction away from the substrate, the first semiconductor layer comprises a channel of the driving transistor and a channel of the bias adjustment transistor, the first metal layer comprises the gate of the driving transistor and a gate of the bias adjustment transistor, and the first connection component is located in the first semiconductor layer.

2. The display panel according to claim 1, **characterized in that** the pixel driving circuit further comprises a first light-emitting control transistor, and the first semiconductor layer further comprises a channel of the first light-emitting control transistor;
the display panel further comprises a light-emitting control signal line extending along a first direction, the light-emitting control signal line comprises a first portion and a second portion electrically connected to each other, and along a direction perpendicular to a plane of the substrate, the first portion overlaps with the channel of the first light-emitting control transistor, and the second portion overlaps with the first connection component;
the first portion comprises a first sub-portion and a second sub-portion that are stacked, and the first sub-portion is electrically connected to the second sub-portion; and
the first sub-portion is located in the first metal layer, and the second sub-portion and the second portion are located on a side of the first metal layer away from the substrate.

3. The display panel according to claim 2, **characterized in that** the pixel driving circuit comprises a connection node electrically connecting the bias adjustment transistor, the first light-emitting control transistor and the driving transistor; and
wherein the channel of the bias adjustment transistor and the channel of the first light-emitting control transistor are respectively located on two sides of the connection node, or the channel of the bias adjustment transistor and the channel of the first light-emitting control transistor are located on a same side of the connection node.

4. The display panel according to claim 2, **characterized in that** the light-emitting control signal line further comprises a third portion, along the direction perpendicular to the plane of the substrate, the third portion does not overlap with the channel of the first light-emitting control transistor or the first connection component, and the third portion and the second portion are provided in a same layer or different layers.

5. The display panel according to claim 2, **characterized in that** the display panel further comprises:
a second metal layer located on a side of the first metal layer away from the substrate, wherein the second portion is located in the second metal layer.

6. The display panel according to claim 1, **characterized in that** the display panel further comprises:
a first scan control signal line and a bias adjustment signal line;
wherein the bias adjustment transistor electrically connects the bias adjustment signal line and the second node, and the first scan control signal line overlaps with the channel of the bias adjustment transistor along a direction perpendicular to a plane of the substrate.

7. The display panel according to claim 6, **characterized in that** the first scan control signal line at least partially overlaps with the bias adjustment signal line along the direction perpendicular to the plane of the substrate.

8. The display panel according to claim 2, **characterized in that** the pixel driving circuit further comprises a first reset transistor electrically connecting the first reset signal line and the first node, and the first reset transistor comprises an oxide transistor;
the display panel further comprises a second semiconductor layer, a second metal layer, and a third metal layer, and the second metal layer is located on a side of the first metal layer away from the substrate; and
the second semiconductor layer is located between the second metal layer and the third metal layer, and the second semiconductor layer comprises a channel of the first reset transistor.

9. The display panel according to claim 8, **characterized in that** the second portion is located in the third metal layer.

10. The display panel according to claim 8, **characterized in that** the display panel further comprises:
a second scan control signal line comprising a fourth portion and a fifth portion, wherein along the direction perpendicular to the plane of the substrate, the fourth portion overlaps with the channel of the first reset transistor, and the fifth portion does not overlap with the channel of the first reset transistor; and
wherein the fourth portion comprises a third sub-portion and a fourth sub-portion that are stacked, the third sub-portion is located in the second metal layer, and the fourth sub-portion and the fifth portion are located in the third metal layer.

11. The display panel according to claim 8, **characterized in that** the pixel driving circuit further comprises a threshold compensation transistor electrically connecting the third node and the first node, and the threshold compensation transistor comprises an oxide transistor; and
the second semiconductor layer comprises a channel of the threshold compensation transistor.

12. The display panel according to claim 11, **characterized in that** the display panel further comprises:
a third scan control signal line comprising a sixth portion and a seventh portion, wherein along the direction perpendicular to the plane of the substrate, the sixth portion overlaps with the channel of the threshold compensation transistor, and the seventh portion does not overlap with the channel of the threshold compensation transistor; and
wherein the sixth portion comprises a fifth sub-portion and a sixth sub-portion that are stacked, the fifth sub-portion is located in the second metal layer, and the sixth sub-portion and the seventh portion are located in the third metal layer.

13. The display panel according to claim 2, **characterized in that** the display panel further comprises:
a first power supply voltage line electrically connected to the first light-emitting control transistor;
a second metal layer and a first source-drain layer, wherein the second metal layer is located on a side of the first metal layer away from the substrate, and the first source-drain layer is located on a side of the second metal layer away from the substrate;
wherein the first power supply voltage line comprises a first power supply voltage sub-line extending along the first direction, the first power supply voltage sub-line comprises a first sub-section and a second sub-section that are stacked, the first sub-section is located in the second metal layer, the second sub-section is located in the first source-drain layer, and the first sub-section is electrically connected to the second sub-section.

14. The display panel according to claim 1, **characterized in that** the data line comprises a first data line;
the display panel further comprises a connection line, the connection line comprises a first connection line and a second connection line electrically connected to each other, the first connection line is electrically connected to the first data line, the first connection line extends along a first direction, the second connection line extends along a second direction, and the first direction intersects with the second direction; and
the second connection line is located on a side of the first connection component away from the substrate.

15. The display panel according to claim 14, **characterized in that** the display panel further comprises:
a first source-drain layer and a second source-drain layer, wherein the first source-drain layer is located on a side of the first metal layer away from the substrate, the second source-drain layer is located on a side of the first source-drain layer away from the first metal layer, the first connection line is located in the first source-drain layer, and the second connection line is located in the second source-drain layer.

16. The display panel according to claim 14, **characterized in that** one of the second connection line and the data line at least partially overlaps with the first connection component along a direction perpendicular to a plane of the substrate.

17. The display panel according to claim 14, **characterized in that** the display panel further comprises:
a light-emitting element electrically connected to the pixel driving circuit;
wherein the pixel driving circuit further comprises a first reset transistor and a second reset transistor;
the first reset transistor electrically connects a first reset signal line and the first node, and the first reset signal line is configured to transmit a first reset voltage;
the second reset transistor electrically connects a second reset signal line and the light-emitting element, and the second reset signal line is configured to transmit a second reset voltage;
the bias adjustment transistor electrically connects a bias adjustment signal line and the second node, and the bias adjustment signal line is configured to transmit a bias adjustment voltage; and
a fixed signal line and the second connection line are located between two adjacent data lines along the first direction, and the fixed signal line is configured to transmit one of the first reset voltage, the second reset voltage and the bias adjustment voltage.

18. The display panel according to claim 17, **characterized in that** the first reset signal line comprises a first reset signal sub-line extending along the second direction;
the second reset signal line comprises a second reset signal sub-line extending along the second direction;
the bias adjustment signal line comprises a first bias adjustment signal sub-line extending along the second direction; and
any two or three of the first reset signal sub-line, the second reset signal sub-line and the first bias adjustment signal sub-line are alternately arranged along the first direction.

19. The display panel according to claim 18, **characterized in that** the first reset signal line further comprises a third reset signal sub-line electrically connected to the first reset signal sub-line, and the third reset signal sub-line extends along the first direction;
the second reset signal line further comprises a fourth reset signal sub-line electrically connected to the second reset signal sub-line, and the fourth reset signal sub-line extends along the first direction; and
the bias adjustment signal line comprises a second bias adjustment signal sub-line electrically connected to the first bias adjustment signal sub-line, and the second bias adjustment signal sub-line extends along the first direction.

20. The display panel according to claim 18, **characterized in that** at least two of the data line, the second connection line, the first reset signal sub-line, the second reset signal sub-line and the first bias adjustment signal sub-line are provided in a same layer.

21. The display panel according to claim 14, **characterized in that** the data line is located between two adjacent second connection lines along the first direction.

22. The display panel according to claim 21, **characterized in that** the display panel further comprises:
a first source-drain layer and a second source-drain layer;
wherein the first source-drain layer is located on a side of the first metal layer away from the substrate, the second source-drain layer is located on a side of the first source-drain layer away from the first metal layer, the first connection line is located in the first source-drain layer, and the second connection line is located in the second source-drain layer.

23. The display panel according to claim 14, **characterized in that** the display panel further comprises:
a shielding component configured to receive a constant signal;
wherein along a direction perpendicular to a plane of the substrate, the shielding component is located between the second connection line and the first connection component, and the shielding component at least partially overlaps with the second connection line and the first connection component; or
wherein along the direction perpendicular to the plane of the substrate, the shielding component is located between the data line and the first connection component, and the shielding component at least partially overlaps with the data line and the first connection component.

24. The display panel according to claim 23, **characterized in that** the pixel driving circuit further comprises a storage capacitor, the storage capacitor comprises a first plate and a second plate, and the first plate overlaps with the channel of the driving transistor along the direction perpendicular to the plane of the substrate;
the first plate is located between the substrate and the second plate; and
the shielding component is electrically connected to the second plate.

25. The display panel according to claim 23, **characterized in that** the bias adjustment transistor electrically connects a bias adjustment signal line and the second node; and
the shielding component is electrically connected to the bias adjustment signal line.

26. The display panel according to claim 23, **characterized in that** the display panel further comprises:
a light-emitting element electrically connected to the pixel driving circuit;
wherein the pixel driving circuit comprises a first reset transistor and a second reset transistor, the first reset transistor electrically connects a first reset signal line and the first node, and the second reset transistor electrically connects a second reset signal line and the light-emitting element; and
the shielding component is electrically connected to the first reset signal line or the second reset signal line.

27. A display device, **characterized by** comprising the display panel according to any one of claims 1 to 26.
